(19) Europäisches Patentamt
European Patent Office
Office européen des brevets

(11) EP 2 492 294 A1

(12) EUROPEAN PATENT APPLICATION

(43) Date of publication:
**29.08.2012 Bulletin 2012/35**

(51) Int Cl.:
***C08F 138/00*** *(2006.01)* ***H01L 51/00*** *(2006.01)*

(21) Application number: **12001026.9**

(22) Date of filing: **16.02.2012**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **28.02.2011 JP 2011041739**

(71) Applicant: **Canon Kabushiki Kaisha**
**Tokyo (JP)**

(72) Inventors:
- **Mitsutake, Kunihiro, Eng.**
  **Tokyo (JP)**
- **Sone, Takeyuki, Eng.**
  **Tokyo (JP)**
- **Yano, Koji, Eng.**
  **Tokyo (JP)**

(74) Representative: **Weser, Thilo**
**Weser & Kollegen**
**Patentanwälte**
**Radeckestrasse 43**
**81245 München (DE)**

# (54) Helical-polyacetylene and device having the helical-polyacetylene

(57) A helical-polyacetylene whose main chain has a helical structure includes a carbon double bond constituting the main chain and a side chain composed of an aromatic five-or six-membered ring that binds to one carbon atom of the carbon double bond. In the atoms constituting the five- or six-membered ring, two atoms binding to the atom that directly binds to the carbon atom of the main chain bind only any of five or six atoms constituting the five- or six-membered ring, and in the atoms constituting the five-or six-membered ring, at least one atom located most distant from the atom that directly binds to the carbon atom of the main chain is carbon.

FIG. 2

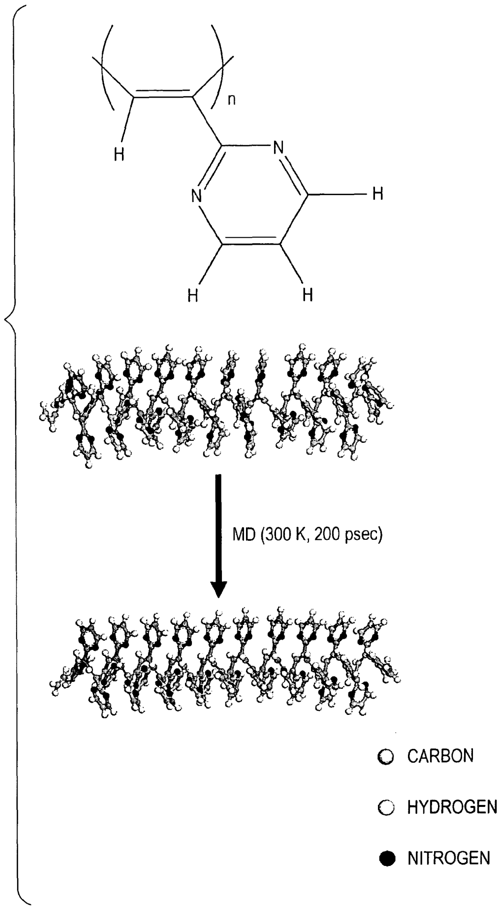


EP 2 492 294 A1

**Description**

BACKGROUND OF THE INVENTION

Field of the Invention

The present invention relates to a helical-polyacetylene, more specifically, a novel helical-polyacetylene used in a conductive polymer material that can be applied to, for example, an electronic device or an optical device.

Description of the Related Art

Recently, organic electronic devices such as transistors and light-emitting devices using organic materials have attracted attention. Many of such organic electronic devices using conjugated polymers can be produced from solutions and can be therefore produced in low costs. Furthermore, application of a solution can easy increase the area thereof and is also advantageous.

Organic electronic devices using conjugated polymers have a possibility of practical application as monomolecular devices each using a single polymer, not an assembly of polymers.

As an example of the conjugated polymer, International Patent Application No. WO 2004/029111 A1 discloses a helical-polyacetylene and a method of producing the helical-polyacetylene. This patent literature discloses a polyacetylene having a helical conjugated structure due to π electrons based on a double bond and including a phenyl group having various functional groups on an end thereof and discloses an assembly of pseudo-hexagonal structures.

In the case of applying such a helical-polyacetylene to a device, the material may be required to have high stiffness. When a helical-polyacetylene having high stiffness is used in an electronic device, it is expected, for example, to form a monomolecular device that bridges between source and drain electrodes with an isolated single-molecule. It is also expected to impart better electric conduction characteristics to a device by that a regular helical structure of a single polymer molecule is formed due to the high stiffness and, thereby, that conduction of a carrier is prevented from being affected by, for example, a disturbance of the structure.

SUMMARY OF THE INVENTION

Aspects of the present invention provide a helical-polyacetylene having high stiffness and a device using the helical-polyacetylene.

The present invention in its first aspect provides a helical-polyacetylene as specified in claims 1 to 5.

The present invention in its second aspect provides a device as specified in claims 6 and 7.

According to aspects of the present invention, a helical-polyacetylene having high stiffness and a device using the helical-polyacetylene can be provided.

Further features of the present invention will become apparent from the following description of exemplary embodiments with reference to the attached drawings.

BRIEF DESCRIPTION OF THE DRAWINGS

Figs. 1A to 1D are explanatory diagrams of a helical-polyacetylene and its geometrical isomers, according to an aspect of the invention.

Fig. 2 is a diagram showing the results of molecular dynamics simulation when the side chain of a helical-polyacetylene is pyrimidine, according to an aspect of the invention.

Fig. 3 is a diagram showing the results of molecular dynamics simulation when the side chain of a helical-polyacetylene is benzene, according to an aspect of the invention.

Figs. 4A to 4C are diagrams showing the results of molecular dynamics simulation when the side chain of a helical-polyacetylene is pyrimidine, according to an aspect of the invention.

Figs. 5A and 5B are diagrams illustrating a dihedral angle.

Fig. 6 is a graph showing potential energies corresponding to interaction between the main chain (planar type) of a polyacetylene and the benzene side chain or the pyrimidine side chain, according to an aspect of the invention.

Figs. 7A and 7B are graphs showing potential energies when the main chain of a polyacetylene changes from a planar type to a non-planar type, which corresponds to a helical structure, according to an aspect of the invention.

Fig. 8 is a diagram showing the results of molecular dynamics simulation when the side chain of a helical-polyacetylene is thiazole, according to an aspect of the invention.

Fig. 9 is a diagram showing the results of molecular dynamics simulation when the side chain of a helical-polyacetylene is oxazole, according to an aspect of the invention.

Fig. 10A is a diagram showing location of conductive sites in a trans-polyacetylene, according to an aspect of the invention.

Fig. 10B is a diagram showing location of conductive sites in a helical-polyacetylene, according to an aspect of the invention.

Fig. 10C is a graph showing comparison of transfer integrals, according to an aspect of the invention.

Figs. 11A and 11B are graphs showing time variation ranges of transfer integral at each site in a helical-polyacetylene, according to an aspect of the invention.

Figs. 12A and 12B are graphs showing spatial distributions of eigenstates and their energies in a pyrimidine side chain HPA and a known POOPA, respectively, according to an aspect of the invention.

Figs. 13A and 13B are graphs showing the calculation results of density of states of a pyrimidine side chain HPA and a known POOPA, respectively, according to an aspect of the invention.

Figs. 14A and 14B are graphs showing changes in space distribution of wave packets with time in a pyrimidine side chain HPA and a known POOPA, respectively, according to an aspect of the invention.

Figs. 15A and 15B are graphs showing changes in diffusion coefficient with time in helical-polyacetylenes, according to an aspect of the invention.

Figs. 16A to 16G are graphs showing the calculation results of diffusion coefficient when contribution of a part of transfer integral is regarded as zero in order to estimate effects of second and third neighboring terms in a known POOPA, according to an aspect of the invention.

Fig. 17 is a graph showing the results of mobility comparison when contribution of a part of transfer integral is regarded as zero in order to estimate effects of second and third neighboring terms in a known POOPA, according to an aspect of the invention.

Fig. 18 is a diagram illustrating a device using a helical-polyacetylene, according to an aspect of the invention.

## DESCRIPTION OF THE EMBODIMENTS

The embodiments of the present invention will now be described in detail.

The helical-polyacetylene according to an aspect of the present invention is a helical-polyacetylene whose main chain has a helical structure. The helical-polyacetylene has carbon double bonds constituting the main chain and side chains composed of aromatic five- or six-membered rings each binding to one carbon atom of the respective carbon double bonds. In the atoms constituting the five- or six-membered ring, two atoms binding to the atom that directly binds to the carbon atom of the main chain bind only any of five or six atoms constituting the five- or six-membered ring. In the atoms constituting the five- or six-membered ring, at least one atom located most distant from the atom that directly binds to the carbon atom of the main chain is carbon.

In the atoms constituting the five- or six-membered ring, the two atoms binding to the atom that directly binds to the carbon atom of the main chain can be the same or different two atoms selected from nitrogen, oxygen, and sulfur.

The aromatic six-membered ring can be a pyrimidine ring, and the pyrimidine ring can bind to the main chain in such a manner that the two nitrogen atoms bind to the carbon atom that directly binds to a carbon atom of the main chain.

The aromatic five-membered ring can be an oxazole ring or a thiazole ring.

The side chain can be a condensed aromatic ring where the five- or six-membered ring is coordinated to another aromatic ring by sharing a bond.

The chemical formula and structure of a helical-polyacetylene of an aspect of the present invention will now be described as an embodiment of the present invention to show that this helical-polyacetylene has high stiffness.

The helical-polyacetylene is briefly described below. Figs. 1A to 1D are explanatory diagrams of a helical-polyacetylene and its geometrical isomers. The term "helical-polyacetylene" refers to a polyacetylene having a helical structure as shown in Fig. 1A where the carbon skeleton of the main chain forms a structure in which C-C single bonds and C=C double bonds are alternately repeated: -C=C-C=C-C=C-. The polyacetylene has other geometrical isomers: trans-transoid, cis-transoid, and trans-cisoid, the structures thereof are shown in Figs. 1B to 1D, respectively. In this notation, the helical type is generally called cis-cisoid. According to quantum chemical calculation, in general, in a polyacetylene not having substituents, that is, in a polyacetylene in which one hydrogen atom binds to each carbon atom of the main chain, the trans-transoid conformation is in the lowest energy level. On the other hand, in the case where the hydrogen atom is substituted with a relatively large functional group, the order of stability among the geometrical isomers changes due to steric hindrance between the side chains or between the side chain and the main chain. As a result, the stability of the helical-polyacetylene increases in some cases. Furthermore, in some cases, a helical-polyacetylene is preferentially formed depending on the properties of, for example, a catalyst, a co-catalyst, or a monomer that is used in the synthesis. For example, even if any isomer of a polyacetylene is energetically stable than the helical type of the polyacetylene, formation of the helical-polyacetylene can be caused when the activation energy in a reaction path from an initial state to a system of the stable isomer is high whereas the activation energy in a reaction path from an initial state to the helical-polyacetylene, i.e., the metastable state, is relatively low.

Throughout the specification, expressions of carbon, hydrogen, nitrogen, oxygen, and sulfur denote the respective atoms.

The helical-polyacetylene according to an aspect of the present invention will now be described.

As an example of the helical-polyacetylene according to an aspect of the present invention, the following chemical formula (1) shows a polymer where pyrimidine is coordinated to a helical-polyacetylene. Pyrimidine is an aromatic molecule where two pairs of carbon-hydrogen groups of benzene are replaced by two nitrogen atoms at the meta-positions to each other. As structural isomers of pyrimidine, when one nitrogen atom is positioned at the ortho-position with respect to the other nitrogen atom, the isomer is called pyridazine, and when positioned at the para-position, the isomer called pyrazine. According to aspects of the present invention, pyridazine and pyrazine are not objects, and pyrimidine is used as the side chain, and the carbon atom lying between two nitrogen atoms at the meta-positions to each other binds to the main chain. This helical-polyacetylene has high stiffness. In this case, no hydrogen protruding to the outside of the ring binds to the two nitrogen atoms. Consequently, repulsion does not occur between the nitrogen and the hydrogen directly binding to a carbon atom of the main chain.

[Formula 1]

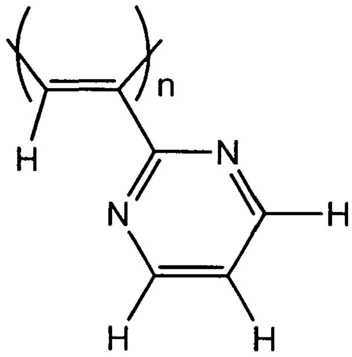

Formula (1)

The results of investigation on stability of this polymer based on simulation are shown below.

Fig. 2 is a diagram showing the results of molecular dynamics simulation when the side chain of a helical-polyacetylene is pyrimidine, wherein the pyrimidine binds to the main chain in such a manner that in the pyrimidine ring, the both sides of the carbon atom binding to the main chain are nitrogen atoms. Fig. 2 shows the results of molecular dynamics simulation when pyrimidine molecules bind to a helical-polyacetylene as the side chains in the above-described arrangement. The molecular dynamics simulation is performed using molecular dynamics simulation software, Forcite, in Materials Studio 4.4 available from Accelrys Inc. As the force field, Universal force field is used. As the charge, a value determined by a QEq method is used. Fig. 2 shows the results of structural optimization by molecular mechanics calculation before the molecular dynamics (hereinafter abbreviated to MD) calculation and after MD calculation at a temperature of 300 K and a time of 200 psec. Here, the state before the MD calculation is the initial state where hydrogen is replaced by pyrimidine in such a manner that the plane of the pyrimidine ring is orthogonal to the helical axis of the stable structure of the helical-polyacetylene not having substituents. In this example, the main chain has 32 C=C bonds, that is, the example is a case of a 32-mer, where one carbon atom of each of the 30 C=C bonds, excluding those at both ends, binds to a pyrimidine molecule. The state determined as a stable structure by molecular mechanics calculation with the above-mentioned software is given as the initial structure of the molecular dynamics simulation.

It is confirmed from Fig. 2 that the main chain of the polymer after the MD has approximately the same helical structure as that before the MD and therefore that the high stiffness is maintained.

Fig. 3 is a diagram showing the results of molecular dynamics simulation when the side chain of a helical-polyacetylene is benzene. Here, for comparison with Fig. 2, Fig. 3 shows the results of similar calculation for polyphenylacetylene, which is a known basic structure, i.e., for a helical-polyacetylene where phenyl groups not having substituents on the outside thereof bind to the main chain. The results are compared to the results shown in Fig. 2 to confirm that the helical-polyacetylene having the pyrimidine side chains according to aspects of the present invention has stiffness higher than that of the polyphenylacetylene as a known basic structure.

In the case using pyrimidine as the side chain of a helical-polyacetylene, the effect of the binding site of the pyrimidine on stiffness was investigated. Figs. 4A to 4C show the results. Figs. 4A to 4C are diagrams showing the results of molecular dynamics simulation when pyrimidine is used as the side chain of a helical-polyacetylene and showing the results for pyrimidine side chains whose binding states with the main chain are different from that in Fig. 2. In the pyrimidine rings of all of the helical-polyacetylenes shown in Figs. 4A to 4C, hydrogen binds to at least one of the

atoms on both sides of the carbon atom that directly binds to the main chain. Therefore, these helical-polyacetylenes do not satisfy the requirements according to aspects of the present invention. The following shows that the stiffness of the polyacetylenes of Figs. 4A to 4C is not high compared to that of the polyacetylene shown in Fig. 2 according to an aspect of the present invention.

The structures shown in Figs. 4A and 4B are similar to each other, and their pyrimidine moieties are inverted to each other. Here, in order to describe the binding states between the main chain and the pyrimidine moiety, atoms are numbered as follows. C(1) and C(2) denote the carbon atoms of the main chain, and the binding between them is a double bond. C(3) denotes a carbon atom of the pyrimidine ring and binding to C(2). N(4) denotes a nitrogen atom of the pyrimidine ring and binding to C(3). The initial conditions are set so that the "dihedral angle" of C(1)=C(2)-C(3)-N(4) is 0° in the case of Fig. 4A and 150° in the case of Fig. 4B.

Throughout the specification, the term "dihedral angle" refers to the same definition as the "dihedral angle" generally used for designating atomic coordinates in, for example, molecular orbital calculation. The "dihedral angle" is described with reference to Figs. 5A and 5B. As shown in Fig. 5A, in four points A, B, C, and D, the point D is assumed to be on the near side with respect to the plane defined by three points A, B, and C. In this case, when atoms at these four points are projected on a plane orthogonal to the direction of the vector BC, that is, the direction of the arrow 1, a view shown in Fig. 5B is obtained. Here, the points corresponding to the points A, B, C, and D projected on the plane are defined as A', B', C', and D', respectively. The points B' and C' are the same point. On this plane of projection, the angle between the line segment B'A' and the line segment B'D' is defined as the dihedral angle of the four points A, B, C, and D.
As shown in Fig. 5B, the angle rotated clockwise from the line segment B'A' to the line segment B'D' is selected a dihedral angle in the forward direction.

In the atoms of the pyrimidine ring shown in Fig. 4C, the atoms on both sides of the carbon atom binding to a carbon atom of the main chain are carbon, and these carbon atoms both bind to hydrogen. In this case, the structure of the pyrimidine ring at the side close to the main chain is similar to that of benzene binding to the main chain shown in Fig. 3. The results of molecular dynamics simulation of those shown in Fig. 3 and Fig. 4C are similar to each other, and the structures of the both have low stiffness.

Comparison of Fig. 2 and Figs. 4A to 4C confirms that when the binding state between the main chain and the pyrimidine side chain of a helical-polyacetylene (Figs. 4A to 4C) is different from that according to aspects of the present invention, the stiffness is lower than that according to aspects of the present invention (Fig. 2) in some cases.

As described above, the structural stability when the side chains of a helical-polyacetylene is benzene differs from that when the side chains of a helical-polyacetylene is pyrimidine, and also the structural stability of a helical-polyacetylene varies depending on the binding site of the pyrimidine. The results of investigation on why such differences occur are shown below.

Fig. 6 is a graph showing potential energies corresponding to interaction between the main chain (planar type) of a polyacetylene and the benzene side chain or the pyrimidine side chain. Fig. 6 shows potential energies when benzene (a) or pyrimidine (b) binding to a plane formed by a part of the main chain of a polyacetylene is rotated. This calculation was performed with first-principle molecular orbital calculation software Gaussian using a density functional theory B3LYP method as the exchange-correlation energy and 6-31G(d) as the basis function. The horizontal axis of Fig. 6 shows the dihedral angle: C(1)=C(2)-C(5)-C(6) (or N(6)). C(1) and C(2) are carbon atoms belonging to the main chain, and C(5) and C(6) (or N(6)) are a carbon atom or a nitrogen atom belonging to the benzene ring (or the pyrimidine ring) of the side chain.

Here, the term "change in dihedral angle" refers to that the benzene or the pyrimidine is virtually rotated with respect to the main chain using C(2)-C(5) as the rotation axis, while fixing the inner structure of each region of these molecular models and without changing the bond length between C(2) and C(5).

Fig. 6 shows that the energy is the highest at a dihedral angle of 0° or 180° in the case of benzene and, on the other hand, in the case of pyrimidine, the energy at a dihedral angle of 0° or 180° is the lowest. The former case (a) can be interpreted that hydrogen atoms at two sites each surrounded by a dashed line come close to each other, this repulsive interaction and an interaction attempting to increase $\pi$ conjugation by arranging the main chain (the left region) C=C double bond and the benzene ring on a plane (in general, energy is low at a dihedral angle of 0° or 180° and high at a dihedral angle of 90°) compete with each other, and the contribution of the repulsive interaction is large to give the potential energy level shown in Fig. 6. On the other hand, the case of (b) of the pyrimidine side chain is interpreted that since no repulsion between hydrogen atoms occurs, the contribution of conjugation is high when the main chain and the pyrimidine ring lie on the same plane to give the lowest energy level.

Figs. 7A and 7B are graphs showing potential energies corresponding to interaction between the main chain and the benzene side chain and interaction between the main chain and the pyrimidine side chain when the main chain of a polyacetylene changes from a planar type to a non-planar type, which corresponds to the helical structure. Figs. 7A and 7B show the results when C(1)=C(2)-C(3)=C(4) of the main chain is a non-planar type. Specifically, Figs. 7A and 7B show the calculation results of potential energies by rotating the side chains as in the case shown in Fig. 6 when

the dihedral angle C(1)=C(2)-C(3)=C(4) of the main chain is changed to 0°, 13°, 26°, 39°, or 52°. The results show that in the case of the benzene side chain, when the dihedral angle of the main chain C(1)=C(2)-C(3)=C(4) is 39° and the dihedral angle between the main chain (lower side) and the benzene ring C(1)=C(2)-C(5)-C(6) is 35° (Fig. 7A (a1)), a most stable state is obtained.

This state corresponds to the case in which the benzene ring is approximately parallel to the helical axis vector when the main chain is in a helical form. This state is called state A here for convenience. It is also confirmed that when the dihedral angle of the main chain C(1)=C(2)-C(3)=C(4) is 39° and the dihedral angle between the main chain (lower side) and the benzene ring is -40° (Fig. 7A (a2)), a metastable state is obtained. This state is corresponds to the case in which the normal vector of the plane of the benzene ring is approximately parallel to the helical axis vector. This state is called state B here for convenience. The state B is a state where benzene rings tend to stack up, and the state A is a state where benzene rings do not tend to stack up. It is recognized that since the state A is stable than the state B energetically, the benzene rings do not tend to stack, resulting in structural instability.

On the other hand, in the pyrimidine side chain shown in Fig. 7B, the energy level is the lowest when the dihedral angle of the main chain C(1)=C(2)-C(3)=C(4) is approximately 39° and the dihedral angle between the main chain (lower side) and the pyrimidine ring is in the range of -5° to 0°, that is, the pyrimidine ring directly binds to the C=C bond of the main chain and the pyrimidine ring and the main chain are in approximately plane forms. It is recognized that in this state, the pyrimidine rings tend to stack, as a result, the structure is stabilized. The difference in structural stability between the helical-polyacetylene having pyrimidine side chains and the helical-polyacetylene having benzene side chains shown in Figs. 2 and 3, respectively, can be thus described.

In the cases where the pyrimidine ring binds to the main chain as shown in Figs. 4A to 4C, as in the case of the phenyl side chain, it is recognized that the hydrogen of the pyrimidine ring comes close to the hydrogen directly binding to the carbon of the main chain and the stiffness thereby decreases.

As described above, it can be understood that the stiffness is increased in a helical-polyacetylene having pyrimidine side chains arranged as shown in Fig. 2.

In application of a polyacetylene to molecular electronic devices, functional groups having useful functions are generally introduced to the side chain. Accordingly, in order to introduce such functional groups, $R_1$, $R_2$, and $R_3$, can be introduced to the pyrimidine ring as shown in the following chemical formula (2).

[Formula 2]

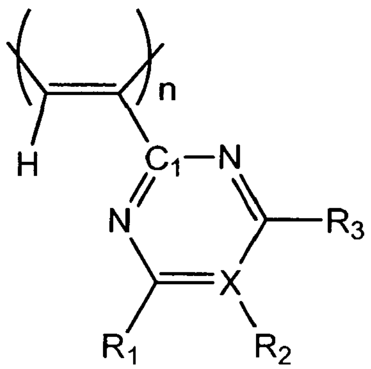

Formula (2)

Examples of the substituents $R_1$, $R_2$, and $R_3$ include alkyl chains, aromatic rings, and functional groups binding through an ester bond or an amide bond according to the purposes of devices, and a predetermined functional group according to a predetermined function may be coordinated. In the substituents $R_1$, $R_2$, and $R_3$, the position of substituent $R_2$ is a position extending toward outside of the helical axis and is generally the most useful position. Accordingly, according to aspects of the present invention, the atom (X in the chemical formula (2)) binding to $R_2$ in the ring, that is, the atom (X) at the position most distant from the atom ($C_1$) binding to the main chain in the six-membered ring is carbon.

Here, in the six-membered ring according to aspects of the present invention, the atom at the position most distant from any atom is defined as follows. In the following chemical formula (3), when six atoms A(1)-A(2)-A(3)-A(4)-A(5)-A(6)-A(1) (the atoms at the left end and the right end are the same) of the six-membered ring are arranged in a ring form, A(2) and A(6) directly bind to A(1) and are each defined as lying at a distance of 1 from A(1). A(3) is distant from A(1) by two bonds in total with A(2) therebetween and is defined as lying at a distance of 2 from A(1). Similarly, A(5) is distant from A(1) by two bonds with A(6) therebetween and is defined as lying at a distance of 2 from A(1). A(4) is distant from A(1) by three bonds with A(2) and A(3) or A(6) and A(5) therebetween and is defined as lying at a distance of 3 from A(1). In the definition described above, when in a ring, the distance from an atom in the clockwise direction and

the distance from the atom in the counterclockwise direction are different from each other, the smaller distance is employed. For example, the distance of A(3) from A(1) is 2 having A(2) therebetween and is also 4 having A(6), A(5), and A(4) therebetween, and the smaller distance, 2, is employed.

[Formula 3]

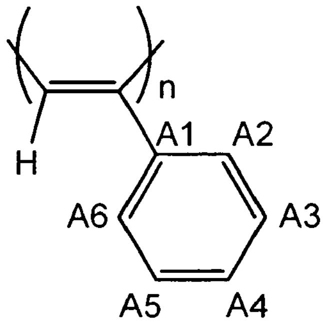

Formula (3)

According to aspects of the present invention, in a six-membered ring, the atom having a largest distance from any atom when defined as in above is defined as the most distant atom. For example, the atom most distant from A(1) is A(4), and the atom most distant from A(2) is A(5). Even if a six-membered ring actually shows thermal motion or causes a difference in actual bond length by binding of a heterogeneous atom, the most distant position is determined as described above by considering only the number of bonds directly binding to each other, without considering the physical distance and the direct distance (shortest distance).

In the above, a polymer having a pyrimidine ring as the side chain binding to a helical-polyacetylene has been described, but similar good structural stability is expected to be given also in a condensed aromatic ring where another aromatic ring is coordinated to the pyrimidine ring. Examples of a polymer having a structure in which a condensed aromatic ring is coordinated as a side chain instead of benzene are shown as the chemical formulae (4) and (5), wherein the condensed aromatic ring is naphthalene or pyrene of which carbon-hydrogen groups adjacent to the carbon binding to the main chain are replaced by nitrogen atoms. In these cases, the atom in the six-membered ring at the position most distant from the atom directly binding to the main chain is carbon.

[Formula 4]

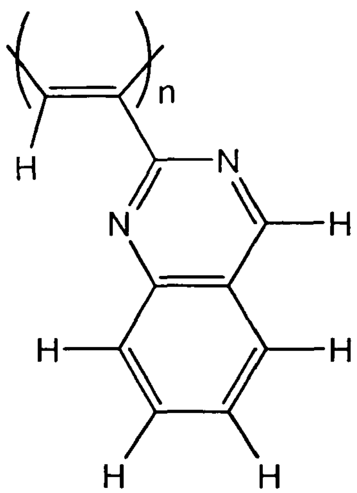

Formula (4)

[Formula 5]

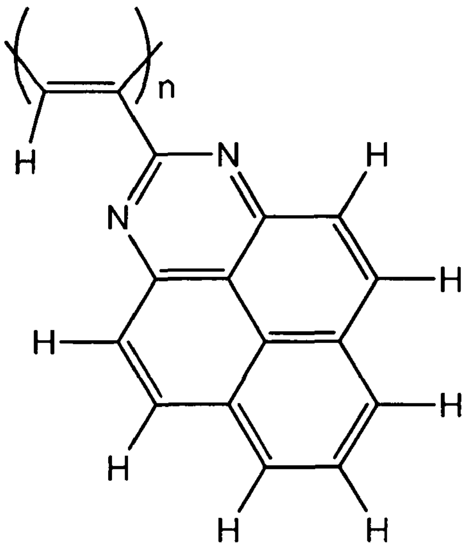

Formula (5)

In the above-mentioned examples, since the side chain does not have protrusion of a hydrogen atom at the site near the main chain, as in that shown in Fig. 2, the stiffness can be improved compared to the case of the phenyl side chain. Even in the case using phenyl as the side chain, it is possible to improve stiffness by introducing a functional group such as an alkyl chain to the phenyl group at the opposite side to the main chain to cause attractive interaction between adjacent functional groups due to van der Waals force or electrostatic force. In such a case, it is thought that the structurally unstable interaction between the main chain and the phenyl group and the attractive interaction between the functional groups on the outside of the phenyl group compete with each other, and when the contribution of the latter is larger than that of the former, the helical structure may be stabilized to improve the stiffness. On the other hand, according to aspects of the present invention, a side chain as shown in Fig. 2 is selected. Such a side chain essentially has stiffness, and it is not necessary to arrange a specific functional group for structural stabilization on the outside of the side chain such as pyrimidine. Therefore, a functional group having a predetermined function can be introduced to the side chain. Thus, according to aspects of the present invention, freedom of molecular design is highly advantageously increased.

An example of using a five-membered ring instead of the six-membered ring as the side chain of a helical-polyacetylene is shown below. Here, the following chemical formula (6) shows an example of a polymer where a thiazole ring, which is a five-membered ring, binds as a side chain to a helical-polyacetylene. The five-membered ring is coordinated in such a manner that the both sides of the atom in the five-membered ring directly binding to the main chain are a nitrogen atom and a sulfur atom, and no hydrogen atom protruding to the outside of the ring binds to these two atoms, as in the case shown by the chemical formula (1). Consequently, it is expected that the thiazole rings tend to well stack in the helical axis direction to give high stiffness.

[Formula 6]

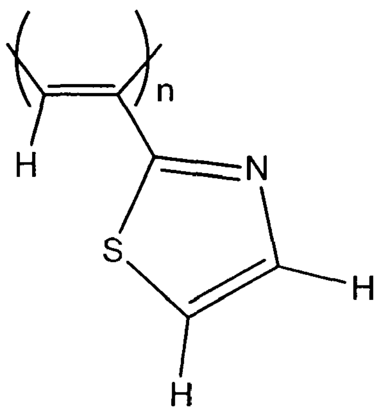

Formula (6)

In order to investigate the stiffness, molecular dynamics simulation (300 K, 200 psec) is performed as in the above-described case. The structures before and after the molecular dynamics simulation are shown in Fig. 8. Fig. 8 is a diagram showing the results of molecular dynamics simulation when the side chain of a helical-polyacetylene is thiazole. Here, the thiazole binds to the main chain in such a manner that the both sides of the carbon atom binding to the main chain are nitrogen and sulfur. The calculation results show that the polymer maintains a satisfactory helical structure.

In also a polymer having oxazole represented by the following chemical formula (7) as the side chain instead of thiazole, as shown in Fig. 9, the results of molecular dynamics (MD) calculation (300 K, 200 psec) show that a satisfactory helical structure is maintained. Fig. 9 is a diagram showing the results of molecular dynamics simulation when the side chain of a helical-polyacetylene is oxazole. Here, the oxazole binds to the main chain in such a manner that the both sides of the carbon atom binding to the main chain are nitrogen and oxygen. Accordingly, this polymer is expected to have high stiffness.

[Formula 7]

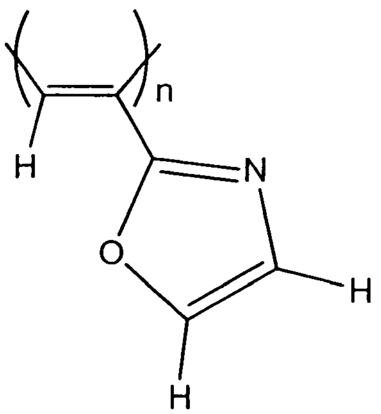

Formula (7)

When these polymers are used as materials for molecular electronic devices, various substituents may be introduced to the outside of the five-membered ring. In such a case, substituents $R_1$ and $R_2$ are introduced to the five-membered ring as shown in the following chemical formula (8).

[Formula 8]

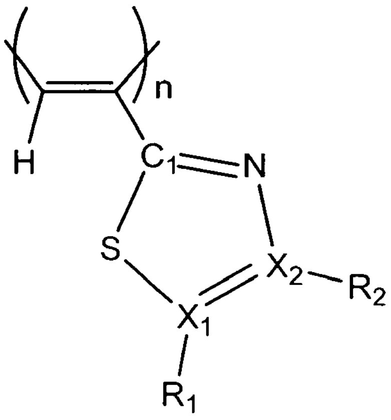

Formula (8)

In the chemical formula (8), S (sulfur) may be replaced by O (oxygen).

The substituents $R_1$ and $R_2$ can bind to the five-membered ring only when at least one of $X_1$ and $X_2$ in the chemical formula (8) is carbon. That is, the binding of substituents $R_1$ and $R_2$ is possible when at least one of the atoms ($X_1$ and $X_2$) at the position most distant from the atom ($C_1$) binding to the main chain in the five-membered ring is carbon.

Here, the atom at the position most distant from any atom in a five-membered ring according to aspects of the present invention is defined as follows. In the following chemical formula (9), when five atoms B(1)-B(2)-B(3)-B(4)-B (5)-B(1) (the atoms at the left end and the right end are the same) of the five-membered ring are arranged in a ring form, B(2) and B(5) directly bind to B(1) and are each defined as lying at a distance of 1 from B(1). B(3) is distant from B(1) by two bonds in total with B(2) therebetween and is defined as lying at a distance of 2 from B(1). Similarly, B(4) is distant from B(1) by two bonds with B(5) therebetween and is defined as lying at a distance of 2 from B(1). In the definition described above, when in a ring, the distance from an atom in the clockwise direction and the distance from the atom in the counterclockwise direction are different from each other, the smaller distance is employed. For example, the distance of B(3) from B(1) is 2 having B(2) therebetween and is also 3 having B(5) and B(4) therebetween, and the smaller distance, 2, is employed. According to aspects of the present invention, in also the five-membered ring, the atom having a largest distance from any atom is defined as the most distant atom, as in the six-membered ring. For example, B(3) and B(4) are the atoms most distant from B(1), and B(4) and B(5) are the atoms most distant from B(2). Even if a five-membered ring actually shows thermal motion or causes a difference in actual bond length by binding of a heterogeneous atom, the most distant position is determined as described above by considering only the number of bonds directly binding to each other, without considering the physical distance and the direct distance (shortest distance).

[Formula 9]

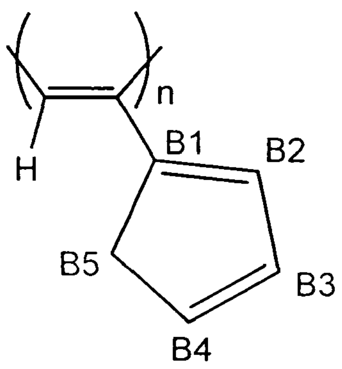

Formula (9)

Examples of a polymer expected to have a similar effect include helical-polyacetylenes having side chains represented by the following formulae (10) to (12).

[Formula 10]

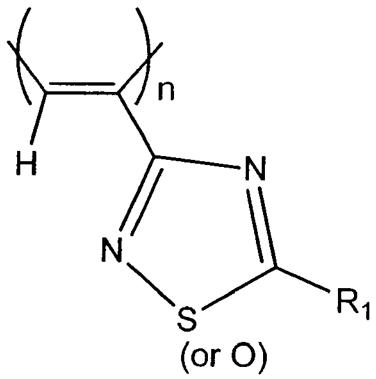

Formula (10)

[Formula 11]

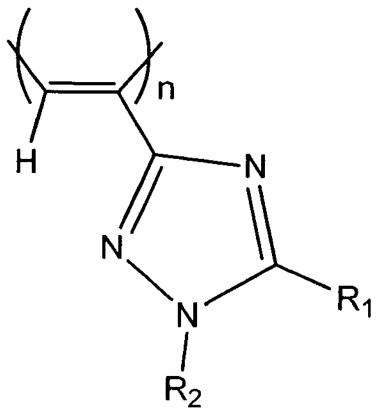

Formula (11)

[Formula 12]

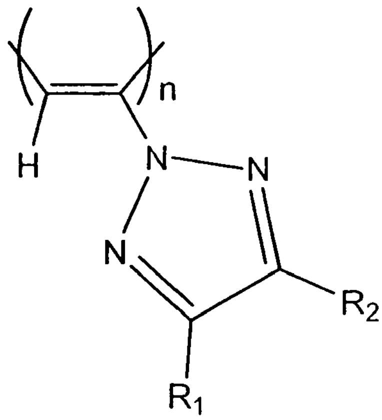

Formula (12)

In these chemical formulae, in the atoms constituting the five-membered ring, both atoms on both sides of the atom binding to the main chain are nitrogen, and no hydrogen protruding to the outside of the five-membered ring binds to these two nitrogen atoms. Examples of the substituents $R_1$ and $R_2$ include alkyl chains, aromatic rings, and functional groups binding through an ester bond or an amide bond according to the purpose of devices, and a predetermined

functional group according to a predetermined function may be coordinated.

The side chain may be a condensed aromatic ring where another aromatic ring is coordinated to a five-membered ring as represented by the following chemical formula (13). In also this case, in the five-membered ring, the two atoms located most distant from the atom directly binding to the main chain are carbon.

[Formula 13]

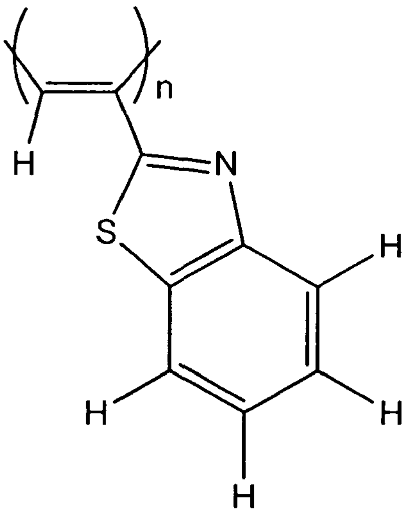

Formula (13)

The helical-polyacetylene according to an aspect of the present invention may be produced by any method without particular limitation. For example, the helical-polyacetylene can be prepared by polymerizing substituted acetylene in a solvent using a stereospecific polymerization catalyst for the substituted acetylene, for example, a transition metal complex such as rhodium.

The solvent may be any solvent that can dissolve the substituted acetylene, and examples thereof include organic solvents such as chloroform and toluene.

The stereospecific polymerization catalyst for the substituted acetylene is not particularly limited, and examples thereof include complexes where a circular diolefin compound is coordinated to monovalent rhodium. More specific examples thereof include rhodium(norbornadiene) complexes and rhodium(cyclooctanediene) complexes.

In the helical-polyacetylene according to aspects of the present invention, in the atoms constituting a five-or six-membered ring side chain, two atoms binding to the atom directly binding to a carbon atom of the main chain bind to only the atoms constituting the five- or six-membered ring side chain, and, therefore, no atom such as hydrogen protruding to the outside of the ring binds to these two atoms. Consequently, repulsion against the hydrogen atoms directly binding to the carbon atoms constituting the polyacetylene skeleton of the main chain does not occur, and the C=C double bond of the main chain and the five- or six-membered ring take approximately planar structures, resulting in stabilization of the helical-polyacetylene. As a result, the five- or six-membered rings are satisfactorily stacked in the direction of the helical axis of the polyacetylene to increase the stiffness of the helical-polyacetylene.

In the helical-polyacetylene according to aspects of the present invention, when the aromatic ring is a six-membered ring, it is possible to introduce a functional group having a function to the six-membered ring at the opposite side to the main chain by arranging a carbon atom at the position most distant from the atom directly binding to a carbon atom of the main chain. Similarly, when the aromatic ring is a five-membered ring, it is possible to introduce a functional group having a function to the five-membered ring at the opposite side to the main chain by arranging a carbon atom at least one of the two positions most distant from the atom directly binding to a carbon atom of the main chain.

A device using a helical-polyacetylene will now be described. The helical-polyacetylenes described above have high stiffness and thereby have high conductivity. This will now be shown using theoretical calculation. Note that the analytical method used here is not a specific one but a general one.

A factor influencing on conductivity is transfer integral, which is a useful parameter. Here, the transfer integral used according to aspects of the present invention and its calculation method are briefly described. The transfer integral is calculated by $<\varphi_1|H|\varphi_2>$.

H is Hamiltonian of the system. The wave functions $\varphi_1$ and $\varphi_2$ are, respectively, the target molecular orbital of a first molecule and the target molecular orbital of a second molecule. Here, one site is n orbital formed by one C=C (actually, an ethylene-type molecule), and since holes are defined as a carrier, the wave functions $\varphi_1$ and $\varphi_2$ are each

a highest occupied molecular orbital (HOMO) of an ethylene molecule. These are determined by first-principles quantum-chemical calculations.

As actual software, according to aspects of the present invention, Gaussian (B3LYP/6-31+G(d)) available from Gaussian Inc. is used. The wave functions $\varphi_1$ and $\varphi_2$ are each superposition of atomic orbitals (bases) $\psi_a$ and $\psi_b$ and are expressed as follows:

$$\varphi_1 = \Sigma_a C_{1a} \psi_a \text{ and } \varphi_2 = \Sigma_b C_{2b} \psi_b$$

wherein the coefficients $C_{1a}$ and $C_{2b}$ and the Fock matrix element $<\psi_a|H|\psi_b>$ can be obtained as outputs of Gaussian.

Here, H is Hamiltonian of the system including the molecules generating target two orbitals. Accordingly, the transfer integral can be calculated by $\Sigma_a \Sigma_b C_{1a}C_{2b} <\psi_a|H|\psi_b>$. Generally speaking, values of transfer integral are negative. Their absolute values are shown hereinafter.

By determining the coordinate of an atom, the predetermined transfer integral can be directly calculated using quantum-chemical calculations at each time. However, in calculations of a huge number of transfer integrals, the transfer integrals can be also empirically obtained by, for example, calculating the transfer integrals in typical cases and constructing an empirical equation using the distance between the centers of C=C bonds of ethylenes and the angles between the normal lines of planes of the ethylenes as parameters. Regarding angular dependence, a literature, J. C. Slater and G. F. Koster., Phys. Rev., 94, 1498 (1954), is helpful.

The values of the above-defined transfer integrals are investigated for trans-polyacetylene (trans-transoid) and helical-polyacetylene (cis-cisoid). Figs. 10A to 10C show the results.

Here, a polyacetylene not having side chains is shown as an example. The first, second, and third neighboring terms each express the arrangement in the main chain: -C=C-C=C-C=C-C=C- by the number of C=C. In the trans type shown in Fig. 10A, the conductive site C=C is aligned one-dimensionally, and the ratio between the distances of first, second, and third neighboring terms is about 1:2:3.

On the other hand, in the helical type shown in Fig. 10B, though the ratio of lengths along the main chain is 1: 2:3, the ratio of linear distances in the real space is about 1:1.4:1.5 (this is based on results of structural optimization by quantum chemical calculations using Gaussian, B3LYP/6-31+G(d), as calculation software and calculation conditions). That is, in the helical-polyacetylene, the second and the third neighboring terms is not largely spaced from each other.

Fig. 10C shows comparison of transfer integrals of the trans- and helical-polyacetylenes. This graph shows that the transfer integral in the first neighboring term of the trans type is larger than that of the helical type, and those in the second and the third neighboring terms of the trans type are approximately zero whereas those of the helical type each show a large value of 0.5 eV. This is one characteristic of the helical-polyacetylene.

The calculation of electric conductivity will now be described.

The literature, H. Ishii, N. Kobayashi, and K. Hirose, Phys. Rev., B 76, 205432 (2007), theoretically describes electric conductivity of a carbon material.

This literature shows the analytical results for electric conduction of carbon nanotube (CNT) by a time-dependent wave-packet method. This time-dependent wave-packet method gives a physical quantity such as diffusion coefficient by solving a time-dependent Schroedinger equation for Hamiltonian based on quantum mechanics using an initial wave packet in a system having a size of several micrometers and calculating time evolution of the wave packet. In addition to CNT, it is possible to investigate electric conduction characteristics reflecting the structure of a helical-polyacetylene of a large size such that the main chain contains hundreds of thousands of C=C.

According to aspects of the present invention, it is shown using this technique that the above-described stiff helical-polyacetylene has high electric conductivity. The molecular dynamics simulation shown in Fig. 2 is conducted for a system of a main chain containing 1000 C=C bonds. Fig. 11A shows calculation results of transfer integrals between first neighbor sites. The material in this case is poly(2-ethynylpyrimidine) as shown in the chemical formula (1).

Here, for comparison, Fig. 11B shows the results of similar transfer integral calculations for a known typical helical-polyacetylene, poly(octyloxyphenylacetylene) (POOPA):

[Compound A1]

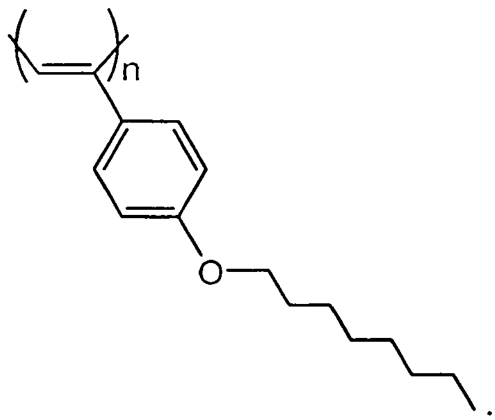

This POOPA is described in Example of Japanese Patent Laid-Open No. 2008-084980.

Figs. 11A and 11B show calculation results of transfer integrals.

The horizontal axis of each of Figs. 11A and 11B shows the site number. The site number is defined as follows. As described above, in this calculation example, the calculation is performed for a helical-polyacetylene having 1000 C=C bonds in the main chain, and the 1000 C=C bonds are successively numbered from No. 1 of the C=C bond at one end to No. 1000 of the C=C bonds at the other end. The vertical axis shows transfer integral between the first neighboring sites.

Specifically, after molecular dynamics simulation at a temperature of 300 K for 200 psec, transfer integrals are calculated from each atomic coordinate for 10 fsec each, 100 times, that is, transfer integrals for 1000 fsec are plotted for each site. The results reveal the range of variation of the transfer integrals.

In the case of a POOPA shown Fig. 11B, the range of variation of the transfer integrals differs in each site and shows variation. On the other hand, in a pyrimidine side chain HPA shown in Fig. 11A, the range of variation in transfer integral does not highly depend on the site and shows less variation compared to POOPA.

The energy region as the target for analysis of diffusion coefficient in this time is the energy region when holes are injected to a helical-polyacetylene. Here, a method for determining an energy region is described. The method for determining an energy region as a target to be calculated is a known method.

Figs. 12A and 12B show the results of determination of eigenstates near the uppermost band of HOMO of HPA by performing diagonalization in a system having 400 conductive sites at time 0. The vertical axis shows energy of its eigenstate, and the horizontal axis determines the position $\mu$ of center and width $\Delta$ of wave function. Specifically, when an eigenfunction is given by $\psi(x)$, the position $\mu$ of center and the width $\Delta$ are determined as follows:

$$\mu = \int x |\psi(x)|^2 \, dx,$$

$$\Delta^2 = \int (x-\mu)^2 |\psi(x)|^2 \, dx.$$

In Figs. 12A and 12B, a range of $\mu-\Delta \leq x \leq \mu+\Delta$ is shown by a line segment. Fig. 12A shows the results of a pyrimidine side chain HPA, and Fig. 12B shows the results of a known POOPA. No eigenstates are present in the range of higher than 2.6 eV. In the range of about 2 to 2.5 eV, since the space distributions of wave function are narrow and energy differences from other states are large, localization of wave functions can be confirmed.

Figs. 13A and 13B show the calculation results of density of states. Here, the term "density of states" refers to a physical quantity showing how many states exist in an energy range. Fig. 13A shows the results of a pyrimidine side chain HPA, and Fig. 13B shows the results of a known POOPA.

The density of states is calculated by the same method (recursion method) as that described in the above-mentioned literature of Ishii, et al. Based on the results thereof, the energy region for investigating diffusion coefficients is determined to a range of 0.4 to 2.6 eV. The base of a peak of density of states extending to a range of higher than 2.6 eV is due to an energy width of 0.05 eV used in the recursion method as the energy resolution of the density of states. Here, the same value as that in the literature of Ishii, et al. is used.

Figs. 14A and 14B show the calculation results of changes with time in space distribution of a wave packet when the wave packet is placed at time 0 at any site of a system having transfer integrals corresponding to Figs. 11A and 11B as parameters of Hamiltonian.

In detail, Figs. 14A and 14B illustrate the results obtained by selecting an x-axis as the axis passing through the center of a helix, segmenting the x-coordinate at each 0.025 $\mu$m, determining the squared-sum of amplitude of the wave function in each range, and multiplying the squared-sum by 200 and adding the multiplied value to the value at each time for facilitating visualization.

Fig. 14A shows the results of a pyrimidine side chain HPA, and Fig. 14B shows the results of a known POOPA. In both polyacetylenes, though the wave packet broadens with time, the distribution of the pyrimidine side chain HPA according to aspects of the present invention is rapid compared to the known POOPA.

Figs. 15A and 15B show the results of investigation of diffusion coefficients. Fig. 15A shows the results of a pyrimidine side chain HPA, and Fig. 15B shows the results of a known POOPA.

Here, the diffusion coefficient is a ratio of increase in width of a wave packet estimated for each energy level when the wave packet is placed at time 0 at any site. In general, the diffusion coefficient is a constant value in a diffusive transport regime, and the value agrees with a diffusion coefficient usually used.
The calculations shown in Figs. 15A and 15B are performed for polyacetylenes each having 700000 sites, but since the burden of calculations of transfer integrals for 700000 sites is too high, in Figs. 15A and 15B, the values of transfer integral shown in Figs. 11A and 11B are spatially arranged again.

It is known that in the case of repeating transfer integral, merely repetition using the same phase may cause artificial rapid diffusion. Accordingly, information not including abnormal diffusion can be obtained by repeating transfer integral while changing the phase in assignment of transfer integral. As described above, the diffusion coefficient is determined in an energy region of 0.4 to 2.6 eV.

In the known POOPA shown in Fig. 15B, the diffusion coefficient is approximately saturated at about 1 $nm^2$/fsec. On the other hand, in the pyrimidine side chain HPA, the diffusion coefficient is higher than 10 $nm^2$/fsec. This value is higher than ten times that of the known POOPA. As shown in Figs. 11A and 11B, the variation in transfer integral is small due to the high stiffness, which probably causes the diffusion coefficient that is ten times larger than that of the known polyacetylene.

According to Einstein's relation, mobility and diffusion coefficient are proportional to each other when the temperature is constant. That is, it has been shown by simulation that the mobility of the HPA is also ten times larger than that of the known polyacetylene.

In the description of Figs. 10A to 10C, it has been described that the transfer integrals of the helical-polyacetylene are large not only in the first neighboring term but also in the second and the third neighboring terms to some extents. The effects of this on electric conductivity will now be briefly described.

Here, a calculation example for a known POOPA is shown as an example.

In order to investigate effects of transfer integrals between the second and third neighboring sites, specifically, changes in diffusion coefficient are investigated when a part of transfer integrals between the first, second, and third neighboring sites are set to 0. Figs. 16A to 16G show the results.

Fig. 16A shows calculation results "1+2+3" including all the transfer integrals between the first, second, and third neighboring sites, and the results are the same as those shown in Fig. 15B. Fig. 16G shows the calculation results "1+2" of diffusion coefficient in wave-packet evolution using the transfer integral values between the first and second neighboring sites without modification and forcibly setting all the values of the third neighboring term to zero. The results of various combinations of ON/OFF of these values are shown in Figs. 16A to 16G. The broadening parameter values are approximately constant after passage of sufficient time in every case shown here. These values can be recognized as diffusion coefficients in diffusion regions. Mobility $\mu$ can be calculated by applying the diffusion coefficient (D) determined above to the Einstein's relation:

$$\mu = \frac{eD}{kT}$$

wherein k represents Boltzmann's constant, T represents the absolute temperature, and e represents quantum of electricity.

Fig. 17 shows the calculation results of mobility. In Figs. 16A to 16G, diffusion coefficient for each energy level is calculated, and, after passage of sufficient time, the difference in diffusion coefficient depending on the energy level is not large. Accordingly, here, the averages of diffusion coefficients are used.

Fig. 17 reveals that the mobility in the first neighboring term only, the second neighboring term only, or the third neighboring term only is significantly small. In these cases, the conduction path is only one. Consequently, if a transfer

integral at any portion is decreased by fluctuation of transfer integral, the conductivity communicating with the portion is probably inhibited to easily cause localization. The mobility in the "1+2" is larger than the sum of the mobility in the "1" and the mobility in the "2". This can be interpreted that in a case having a plurality of paths, even if the transfer integral of one of the paths is decreased by fluctuation, conduction through another path is possible, resulting in high mobility. The mobility in the "1+2+3" is further larger than that in "1+2". Thus, the second and the third neighboring terms of transfer integral are increased due to the characteristic helical structures, resulting in inhibition of localization. The helical-polyacetylene has such interesting characteristics.

In this example, a known POOPA has been investigated as an object. The pyrimidine side chain HPA also has a similar helical structure. Consequently, the second and the third neighboring terms of transfer integral are large, and localization is prevented.

## Examples

### Example 1

As Example 1 of the present invention, a stiff helical-polyacetylene having a six-membered ring side chain is described. Here, a method of producing poly(2-ethynylpyrimidine) is described.

2-Ethynylpyrimidine is produced from 2-bromopyrimidine (CAS No. 4595-60-2) by a known method (reference: E. T. Sabourin, J. Org. Chem., Vol. 48, No. 25, 1983).

Twenty-three milligrams of a rhodium(norbornadiene) chloride dimer, 8 mL of chloroform, and 0.1 mL of triethylamine are put in a test tube hermetically sealed after pressure reduction and nitrogen substitution and are stirred at 30°C for 15 min. Subsequently, a solution of 0. 52 g of 2-ethynylpyrimidine in 2 mL of chloroform is poured into the mixture to start polymerization. The reaction is performed at 30°C for 1 hour, and the resulting polymer after sufficient progress of polymerization is washed with methanol and subjected to filtration and vacuum drying for 24 hours to obtain the target poly(2-ethynylpyrimidine) represented by the chemical formula (1).

The thus-produced poly(2-ethynylpyrimidine) is a helical-polyacetylene having high stiffness.

### Example 2

As Example 2 of the present invention, a stiff helical-polyacetylene having a five-membered ring side chain is described. As an example, a method of producing a helical-polyacetylene having thiazole as the side chain represented by the chemical formula (6) is described.

The target poly(2-bromothiazole) can be produced by the same procedure as in Example 1 using 2-bromothiazole (CAS No. 3034-53-5) instead of 2-bromopyrimidine in Example 1.

The thus-produced poly(2-bromothiazole) is a helical-polyacetylene having high stiffness.

### Example 3

As Example 3 of the present invention, a device using a stiff helical-polyacetylene having a six-membered ring side chain is described. Here, a device using poly(2-ethynylpyrimidine) and a method of producing the device are described.

Fig. 18 shows the structure of a device according to this Example. The device according to this Example is formed on a high-doped Si substrate having a thermally-oxidized film of 300 nm thickness on the surface thereof. Platinum electrodes having a thickness of 30 nm and a width of 1 μm are formed with gap intervals of 300 nm by lithography using electron beam exposure and lift-off. Separately, 1.0 mg of the poly(2-ethynylpyrimidine) prepared in Example 1 is dissolved in 1.0 mL of chloroform to prepare a solution having a concentration of 1.0 g/L. A thin film of poly(2-ethynylpyrimidine) is formed by applying this solution to the electrodes to form a device. On this occasion, charge can be transferred between the poly(2-ethynylpyrimidine) and the electrode. In this device, two Pt electrodes function as source and drain electrodes, and the Si substrate operates as a gate electrode and controls a current flowing between the source and drain electrodes by being applied with a voltage.

This Example shows a field-effect transistor device having a gate electrode, and a control electrode is not necessary by using the stiff helical-polyacetylene as a lead. However, the device may include a control electrode.

In this Example, a voltage is applied between electrodes that are in contact with poly(2-ethynylpyrimidine) for allowing a current to flow in the poly(2-ethynylpyrimidine). In addition to this, aspects of the present invention can also be used as a device for transporting electrons, holes, or charge of electrons or holes generated in poly(2-ethynylpyrimidine), more generally, in a helical-polyacetylene to an electrode side. Examples of specific application include solar cells, photosensors, and gas sensors.

Furthermore, even if a charge is not directly transferred between an electrode and a helical-polyacetylene, it

is possible to operate a device as a sensor by providing an insulating region between the electrode and the helical-polyacetylene so that a voltage of the electrode affects the helical-polyacetylene or detecting a voltage generated in the helical-polyacetylene with the electrode.

The helical-polyacetylene according to aspects of the present invention has high stiffness and can be therefore used in, for example, organic electronic devices such as transistors, light-emitting devices, and light-receiving devices using organic materials.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions.

## Claims

**1.** A helical-polyacetylene whose main chain has a helical structure, the helical-polyacetylene comprising:

a carbon double bond constituting a main chain; and
a side chain composed of an aromatic five- or six-membered ring that binds to one carbon atom of the carbon double bond, wherein
in atoms constituting the five- or six-membered ring, two atoms binding to the atom that directly binds to the carbon atom of the main chain bind only any of five or six atoms constituting the five- or six-membered ring; and
in the atoms constituting the five- or six-membered ring, at least one atom located most distant from the atom that directly binds to the carbon atom of the main chain is carbon.

**2.** The helical-polyacetylene according to Claim 1, wherein
in the atoms constituting the five- or six-membered ring, the two atoms binding to the atom that directly binds to the carbon atom of the main chain are the same or different two atoms selected from nitrogen, oxygen, and sulfur.

**3.** The helical-polyacetylene according to Claim 1, wherein
the aromatic six-membered ring is a pyrimidine ring; and
the two atoms binding to the atom that directly binds to the carbon atom of the main chain are both nitrogen atoms.

**4.** The helical-polyacetylene according to Claim 1, wherein
the aromatic five-membered ring is an oxazole ring or a thiazole ring.

**5.** The helical-polyacetylene according to Claim 1, wherein
the side chain is a condensed aromatic ring where the aromatic five- or six-membered ring is coordinated to another aromatic ring by sharing a bond.

**6.** A device comprising:

a helical-polyacetylene according to any one of Claims 1 to 5; and
any of an electrode for transferring charge between the helical-polyacetylene and the electrode, an electrode for applying a voltage to the helical-polyacetylene, or an electrode for detecting a voltage generated in the helical-polyacetylene.

**7.** The device according to Claim 6, further comprising a control electrode.

FIG. 1A

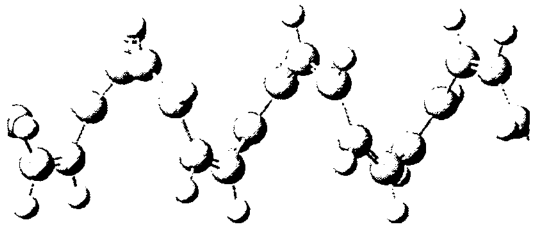

FIG. 1B

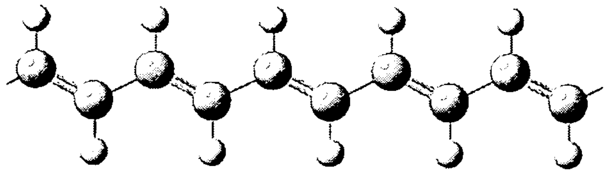

FIG. 1C

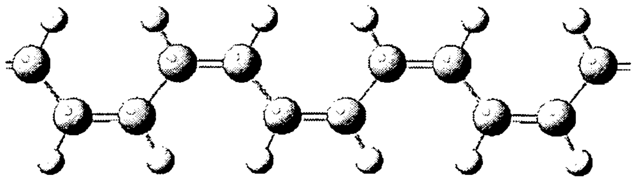

FIG. 1D

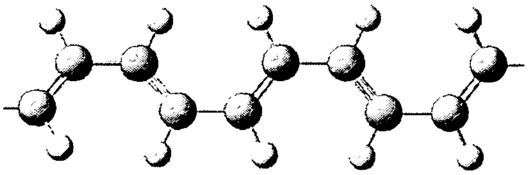

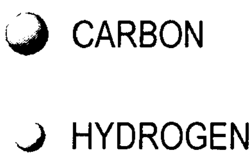

FIG. 2

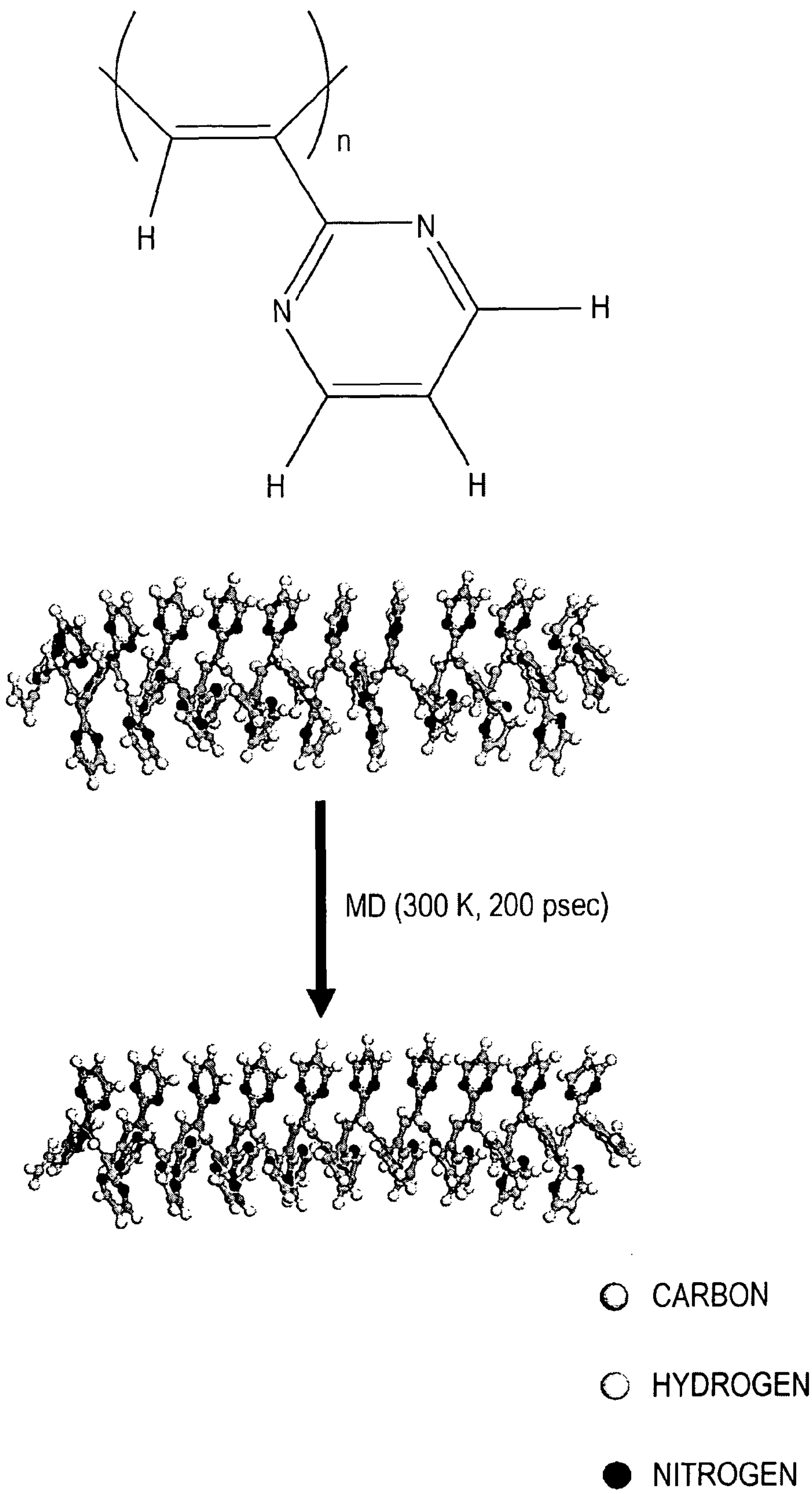

FIG. 3

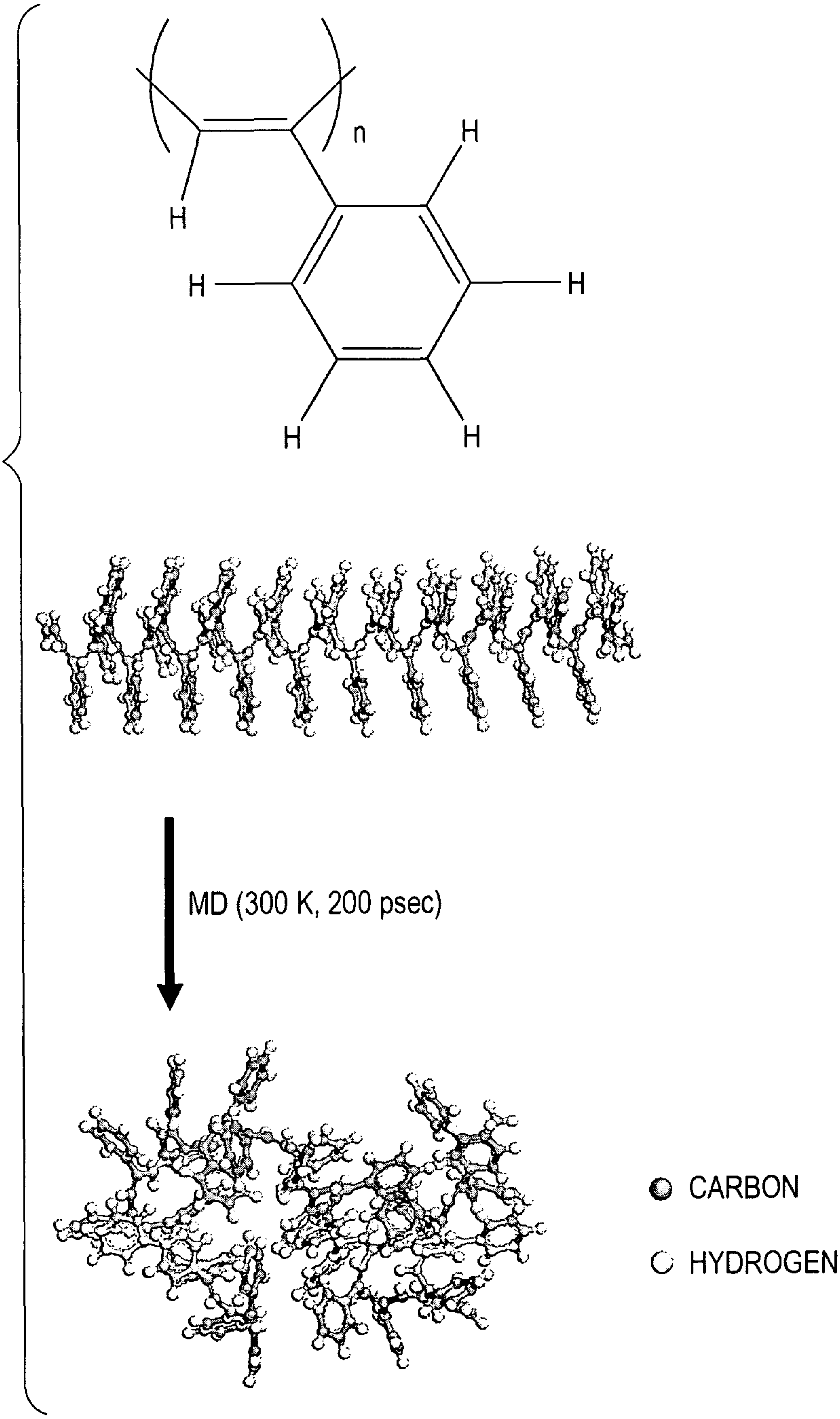

# FIG. 4A

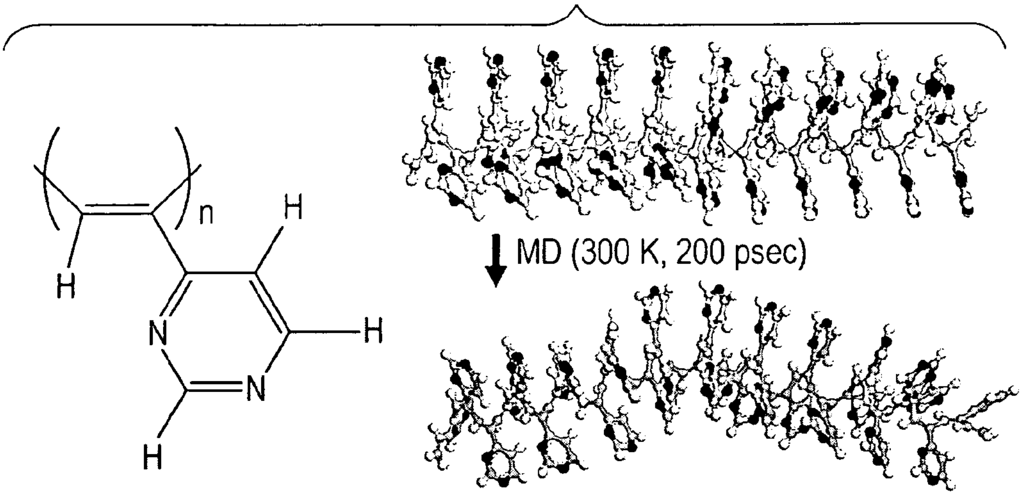


# FIG. 4B

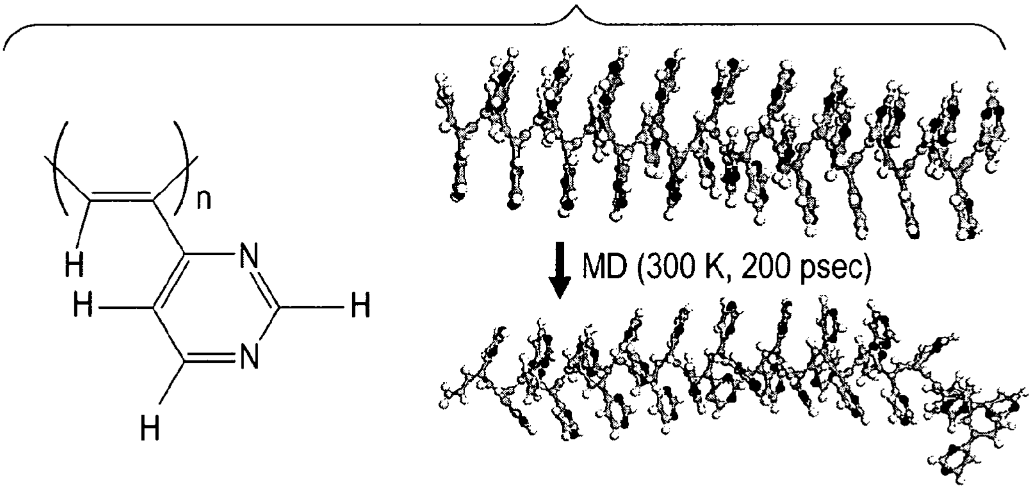


# FIG. 4C

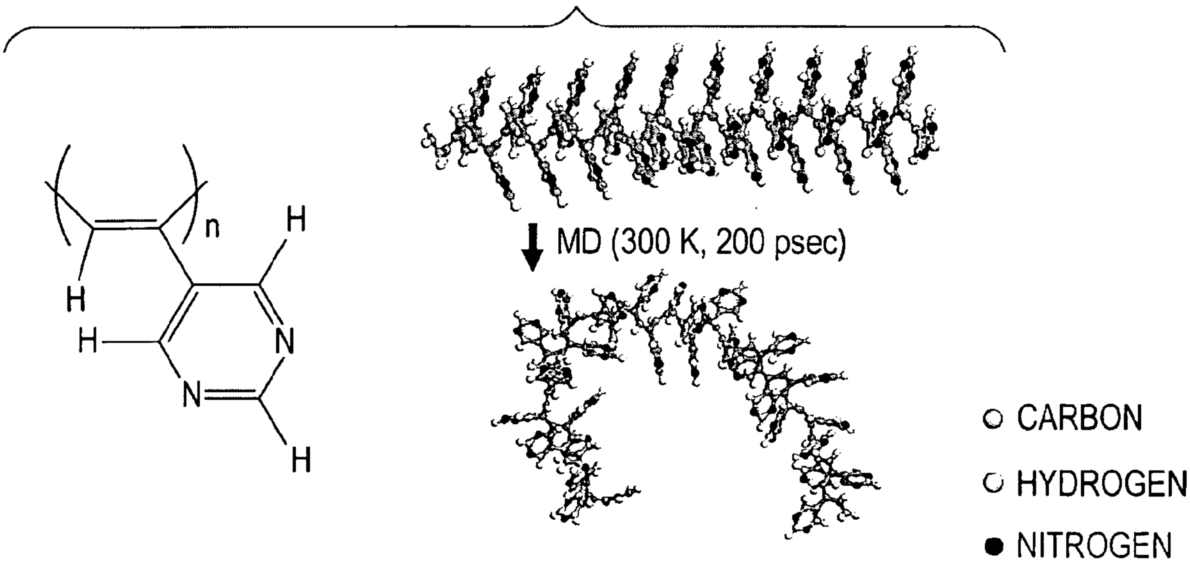

FIG. 5A

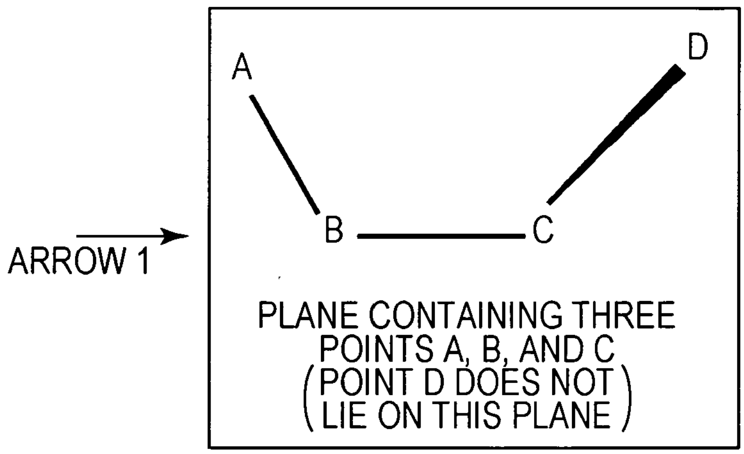
A
D
B
C
ARROW 1
PLANE CONTAINING THREE POINTS A, B, AND C
(POINT D DOES NOT LIE ON THIS PLANE)

FIG. 5B

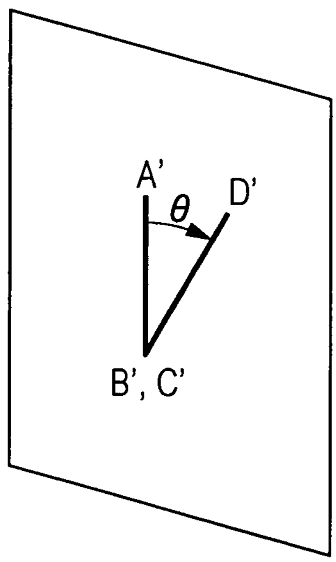
A'
θ
D'
B', C'

FIG. 6

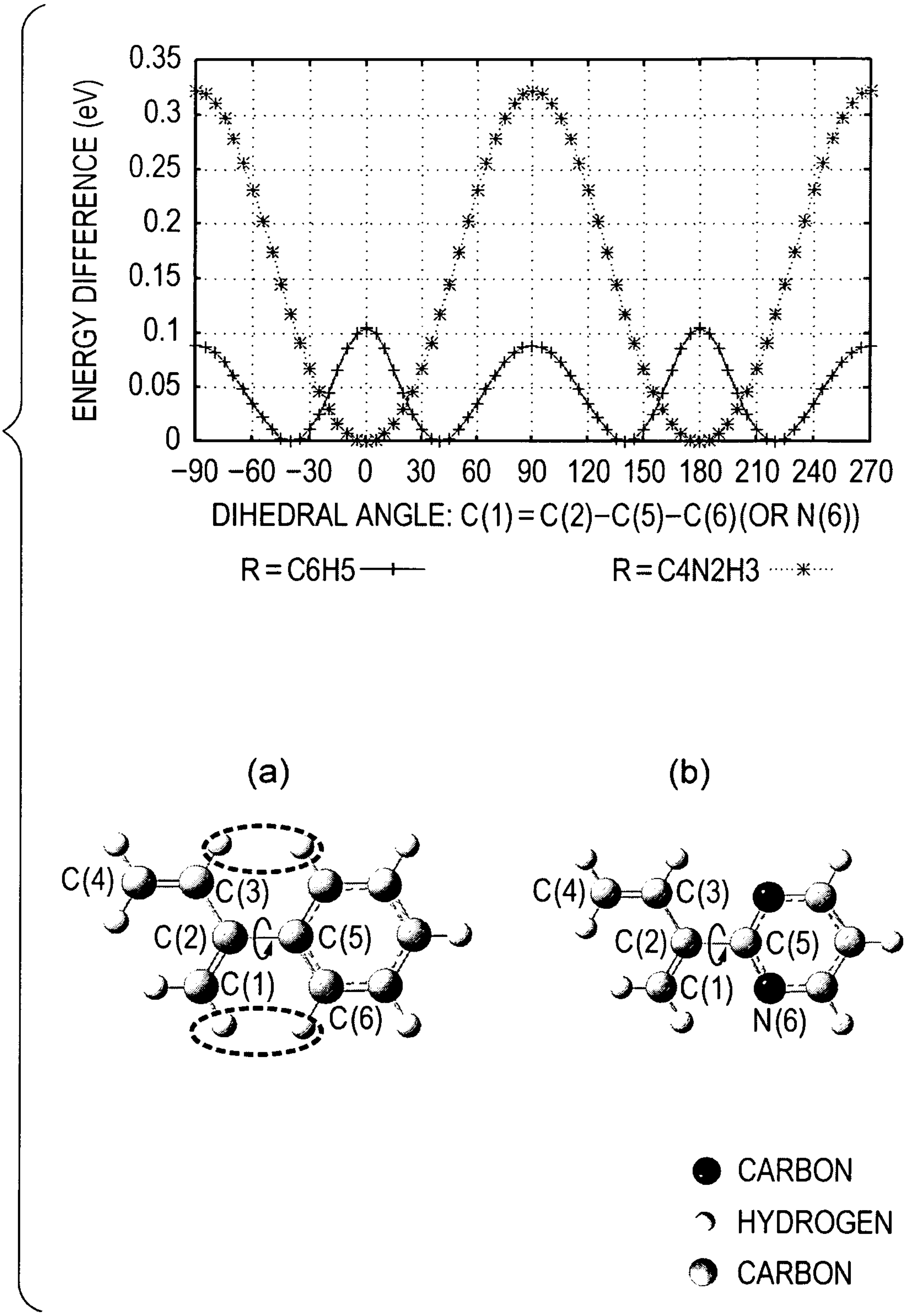
ENERGY DIFFERENCE (eV)
0.35
0.3
0.25
0.2
0.15
0.1
0.05
0
-90 -60 -30 0 30 60 90 120 150 180 210 240 270
DIHEDRAL ANGLE: C(1)=C(2)-C(5)-C(6)(OR N(6))
R=C6H5
R=C4N2H3
(a)
(b)
CARBON
HYDROGEN
CARBON

FIG. 7A

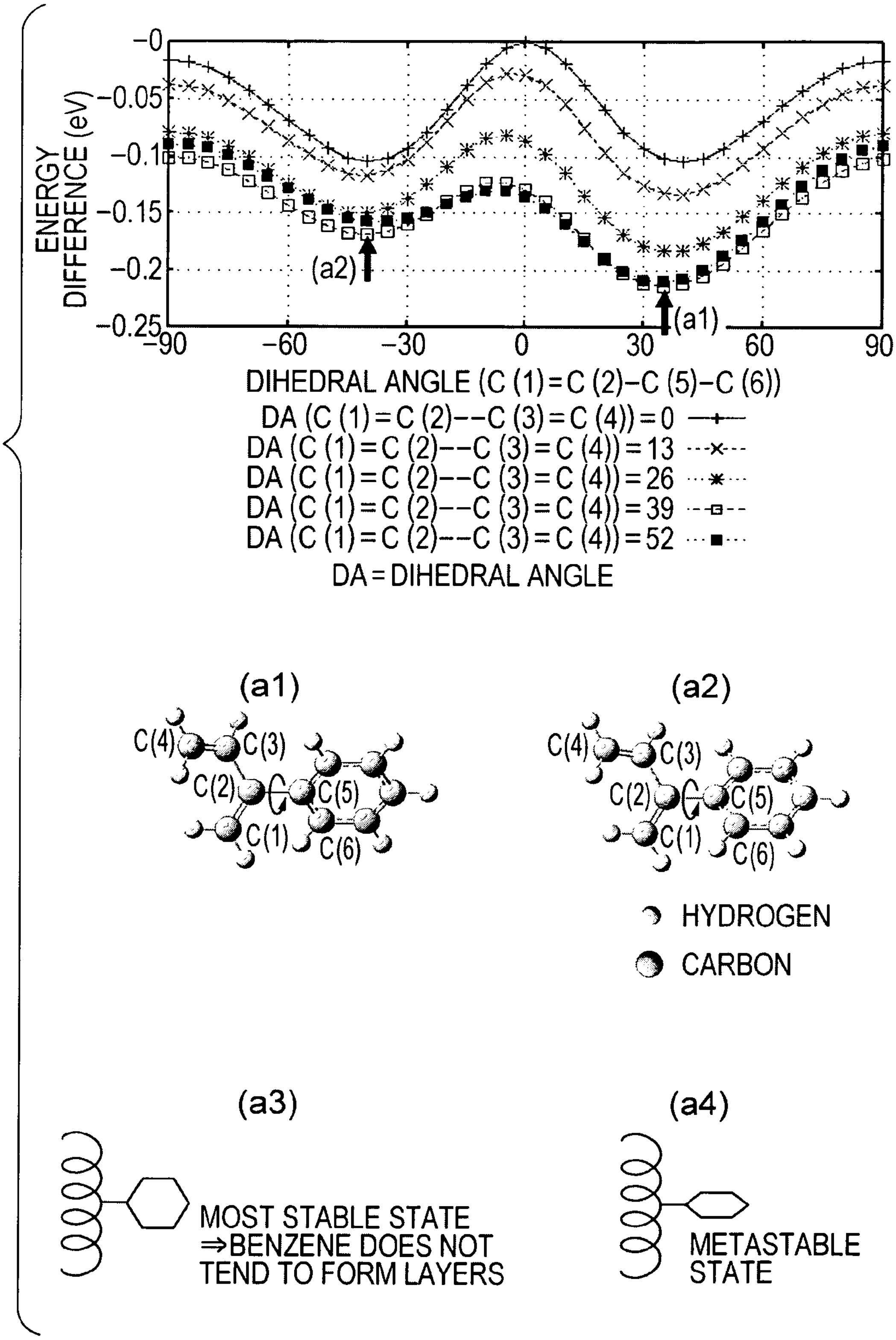

ENERGY DIFFERENCE (eV)
-0
-0.05
-0.1
-0.15
-0.2
-0.25
-90
-60
-30
0
30
60
90
(a2)
(a1)
DIHEDRAL ANGLE (C (1)=C (2)-C (5)-C (6))
DA (C (1)=C (2)--C (3)=C (4))=0
DA (C (1)=C (2)--C (3)=C (4))=13
DA (C (1)=C (2)--C (3)=C (4))=26
DA (C (1)=C (2)--C (3)=C (4))=39
DA (C (1)=C (2)--C (3)=C (4))=52
DA=DIHEDRAL ANGLE
(a1)
(a2)
C(4)
C(3)
C(2)
C(5)
C(1)
C(6)
HYDROGEN
CARBON
(a3)
(a4)
MOST STABLE STATE
⇒BENZENE DOES NOT
TEND TO FORM LAYERS
METASTABLE
STATE

FIG. 7B

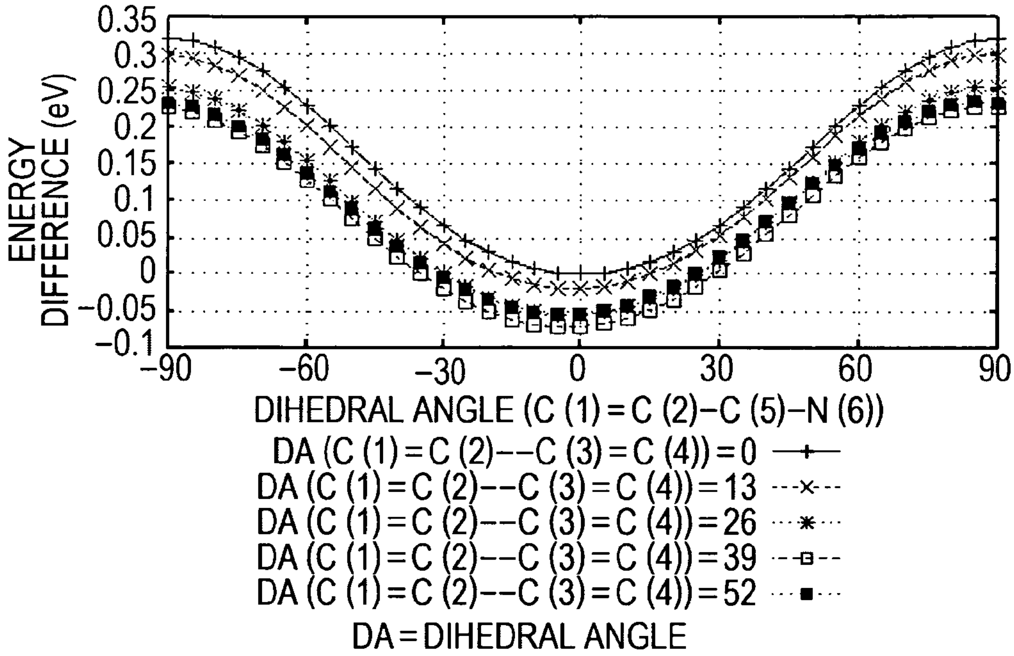
ENERGY DIFFERENCE (eV)
0.35
0.3
0.25
0.2
0.15
0.1
0.05
0
−0.05
−0.1
−90
−60
−30
0
30
60
90
DIHEDRAL ANGLE (C (1) = C (2)−C (5)−N (6))
DA (C (1) = C (2)−−C (3) = C (4)) = 0
DA (C (1) = C (2)−−C (3) = C (4)) = 13
DA (C (1) = C (2)−−C (3) = C (4)) = 26
DA (C (1) = C (2)−−C (3) = C (4)) = 39
DA (C (1) = C (2)−−C (3) = C (4)) = 52
DA = DIHEDRAL ANGLE

(b1)

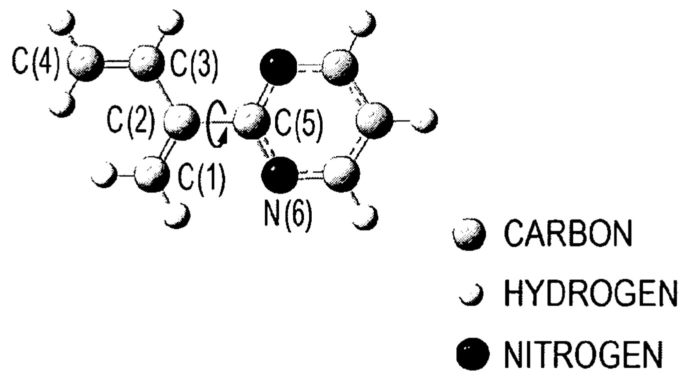
CARBON
HYDROGEN
NITROGEN

(b2)

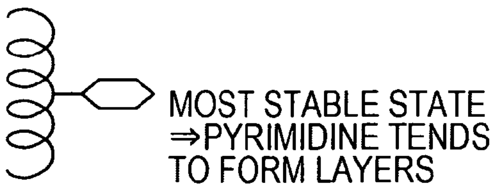
MOST STABLE STATE
⇒PYRIMIDINE TENDS
TO FORM LAYERS

FIG. 8

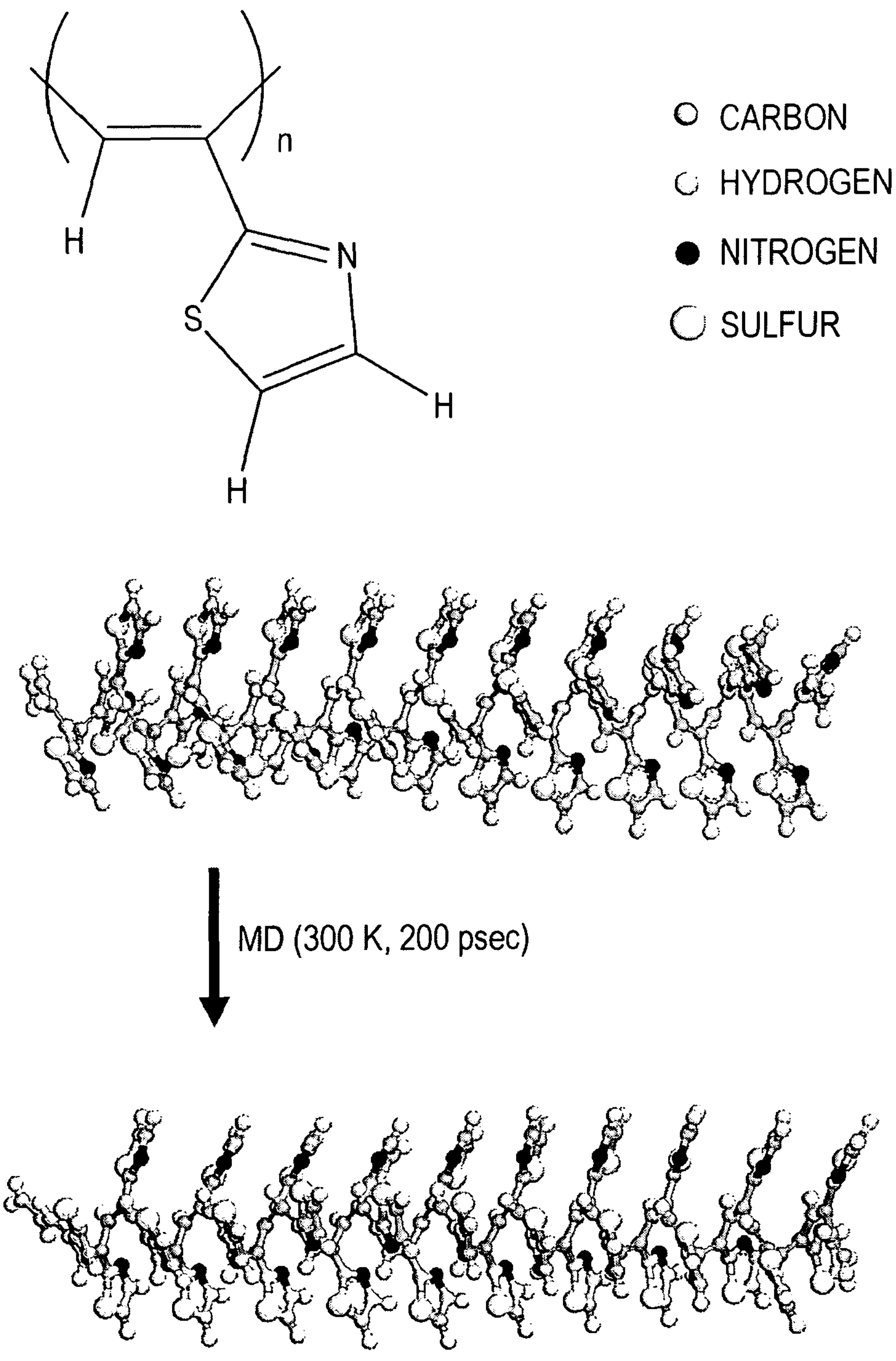

FIG. 9

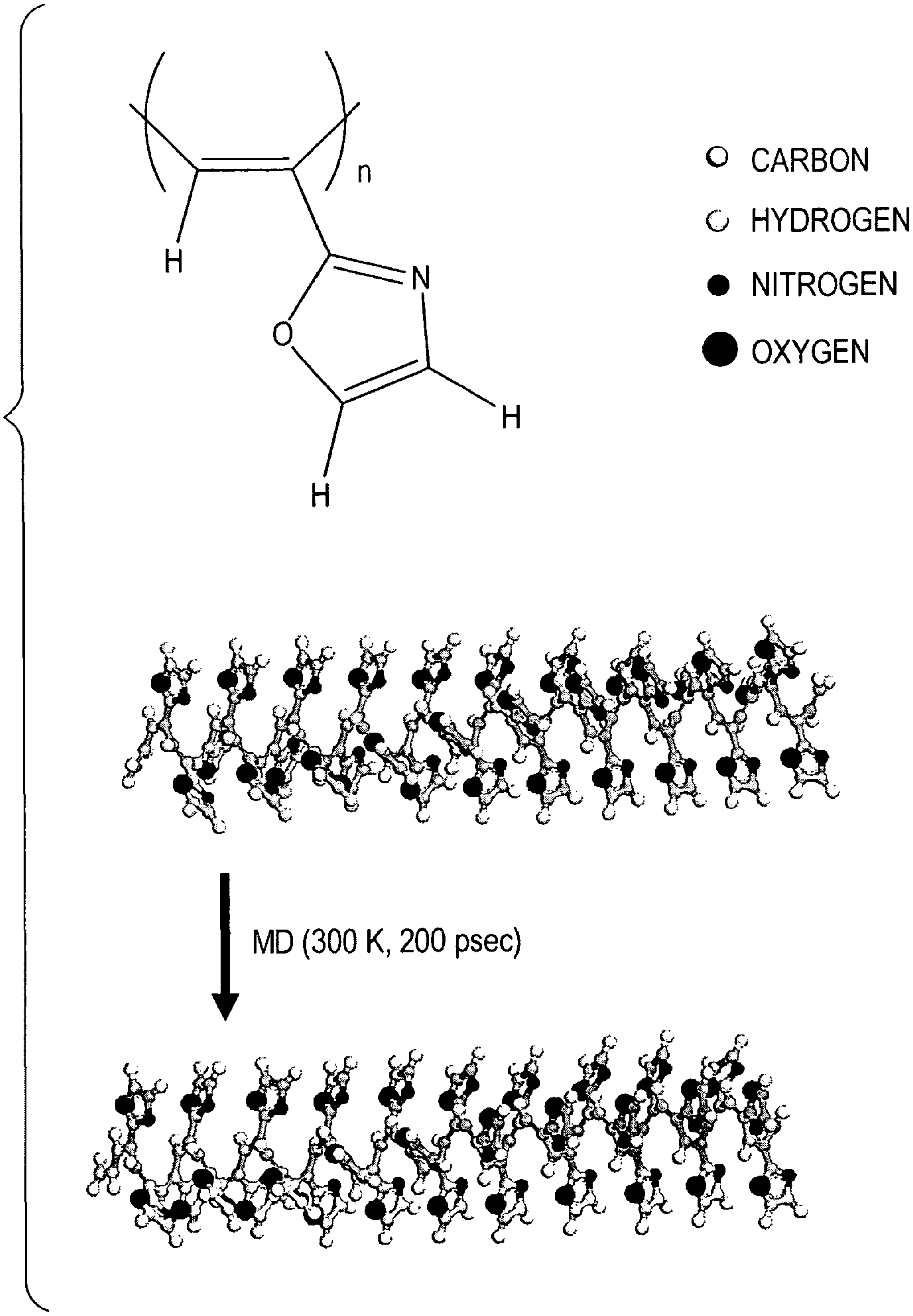

FIG. 10A

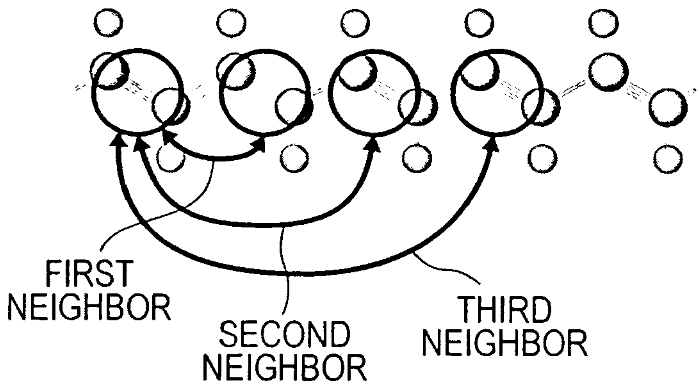


FIG. 10B

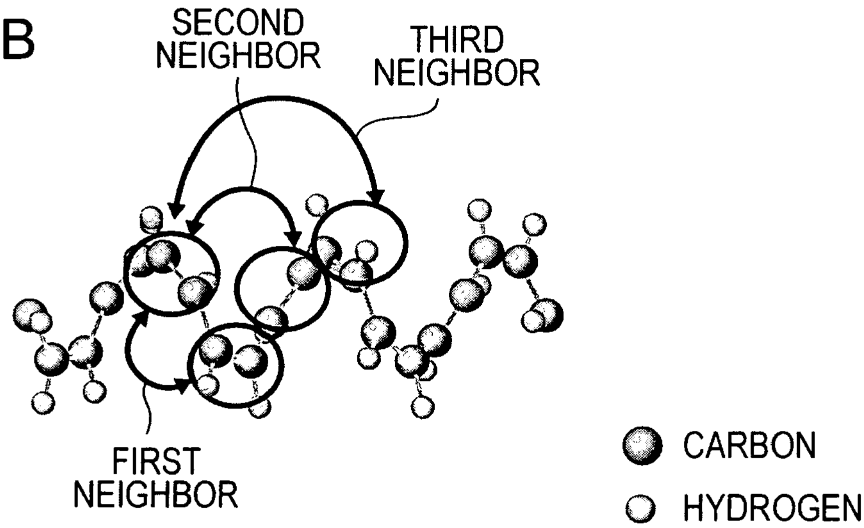


FIG. 10C

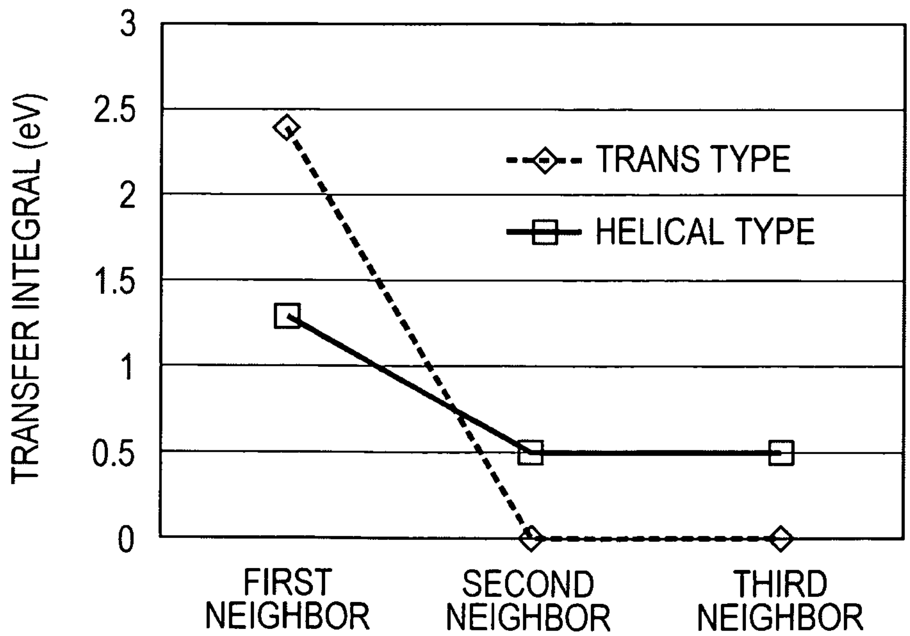

FIG. 11A

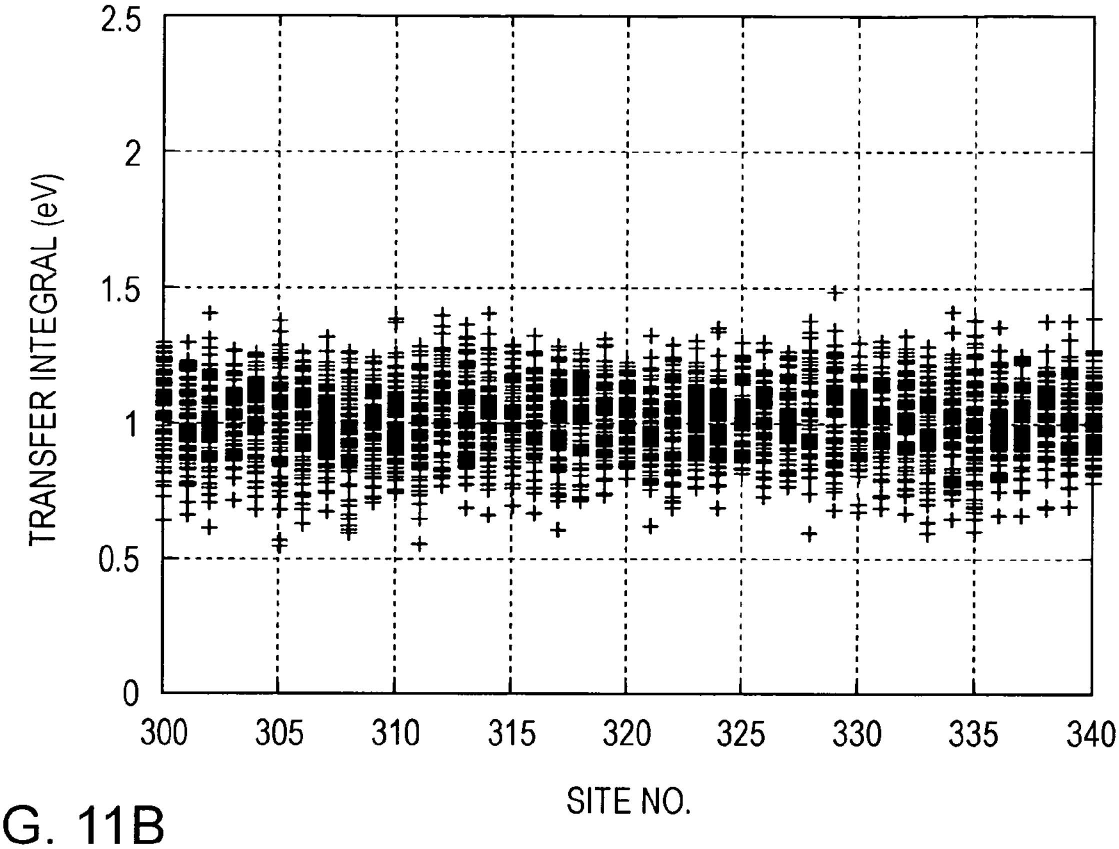


FIG. 11B

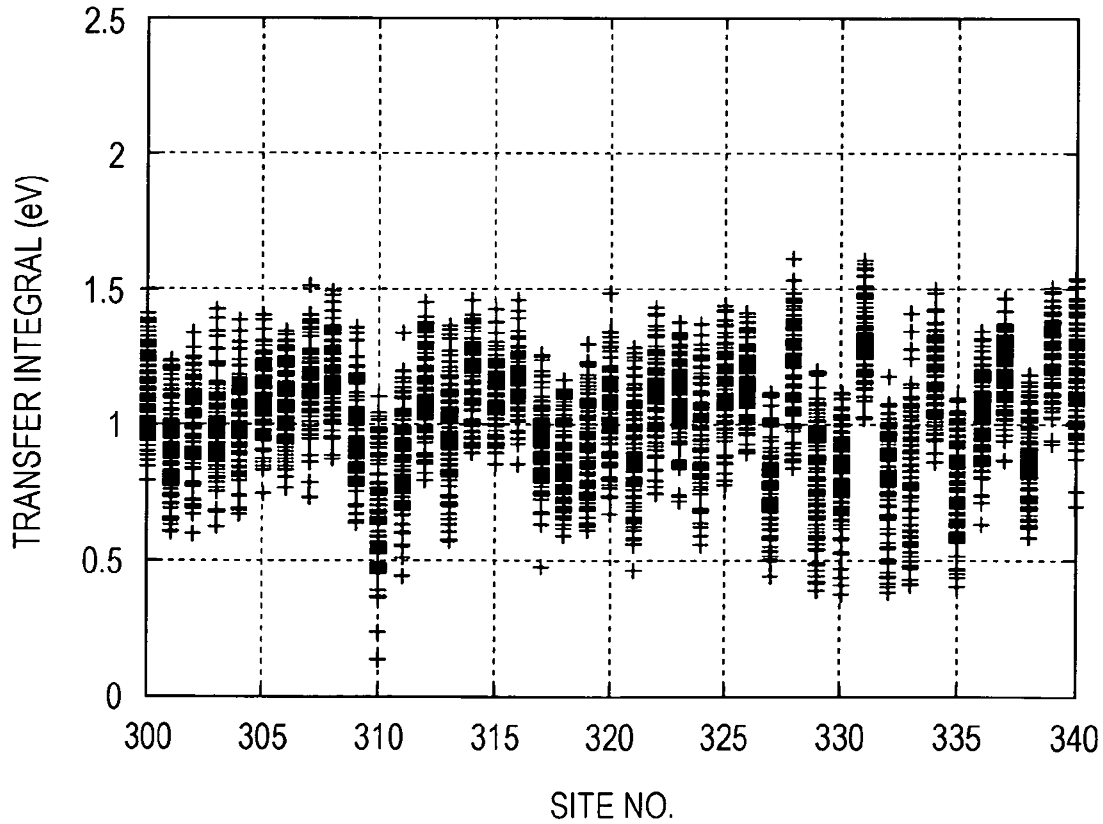

FIG. 12A

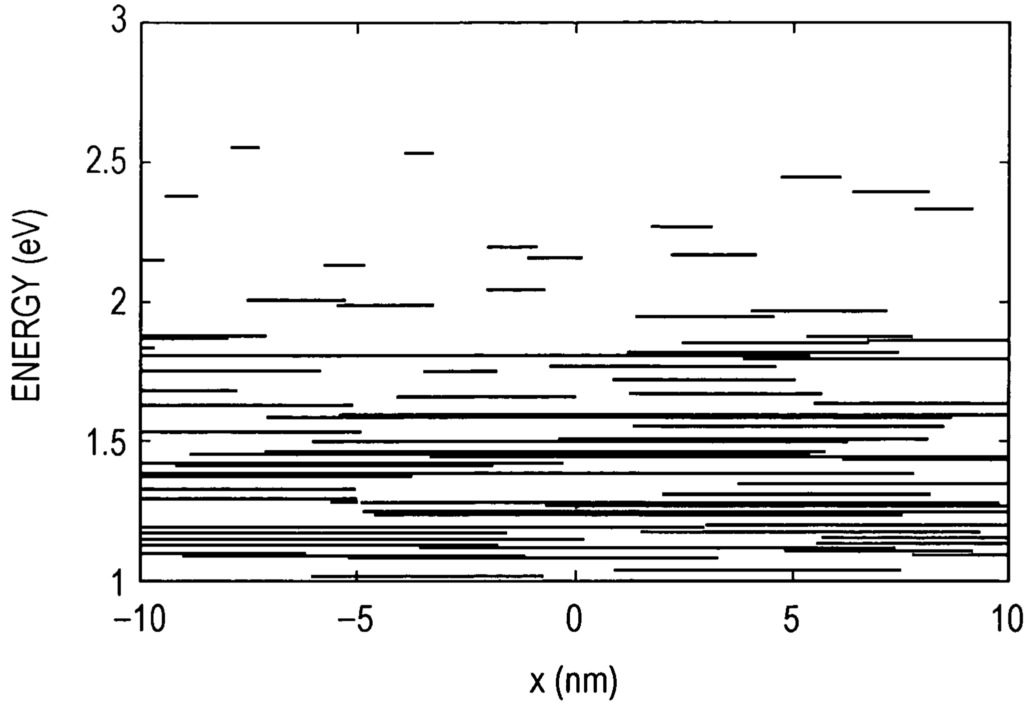


FIG. 12B

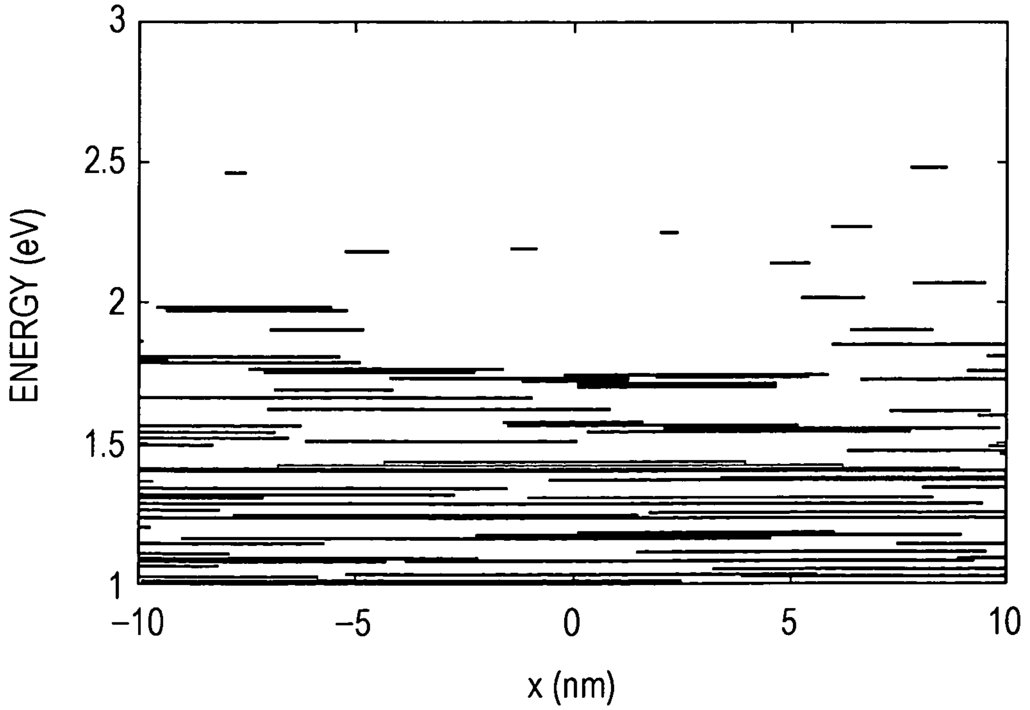

FIG. 13A

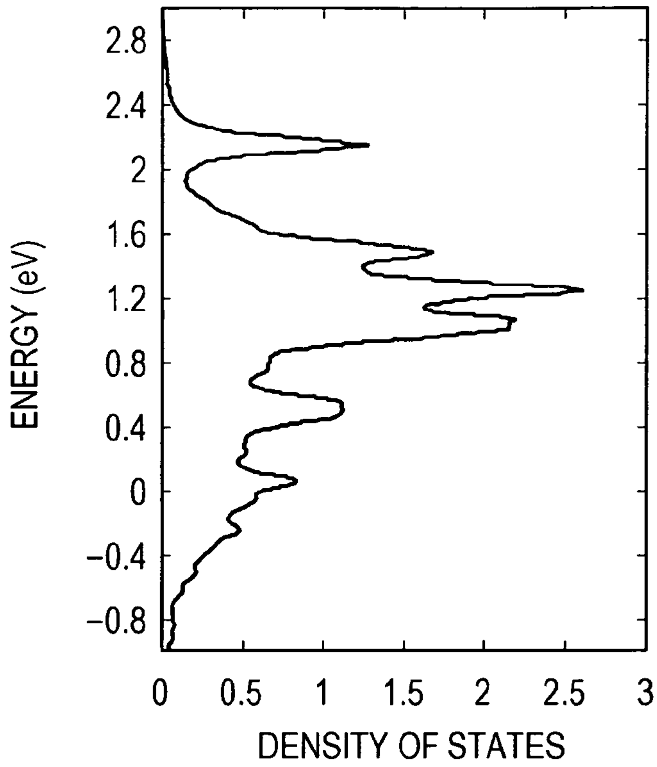


FIG. 13B

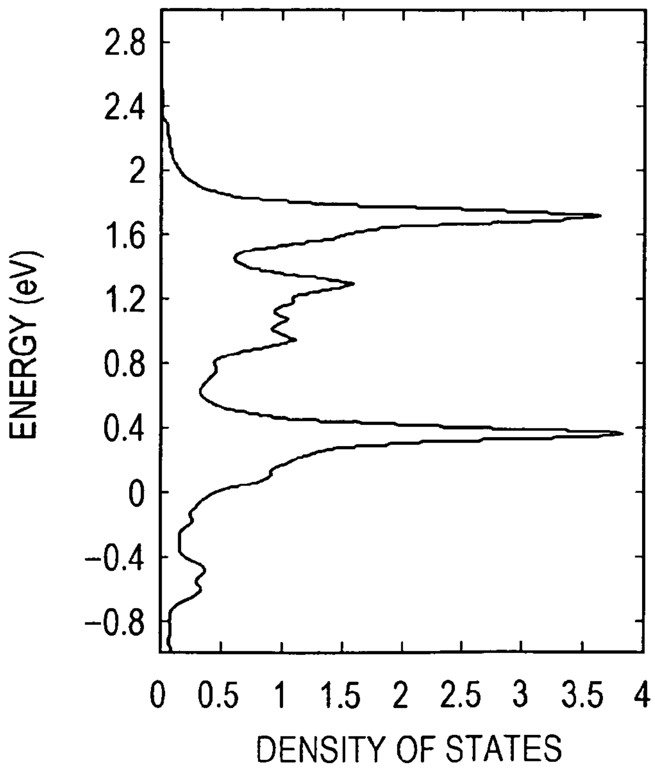

FIG. 14A

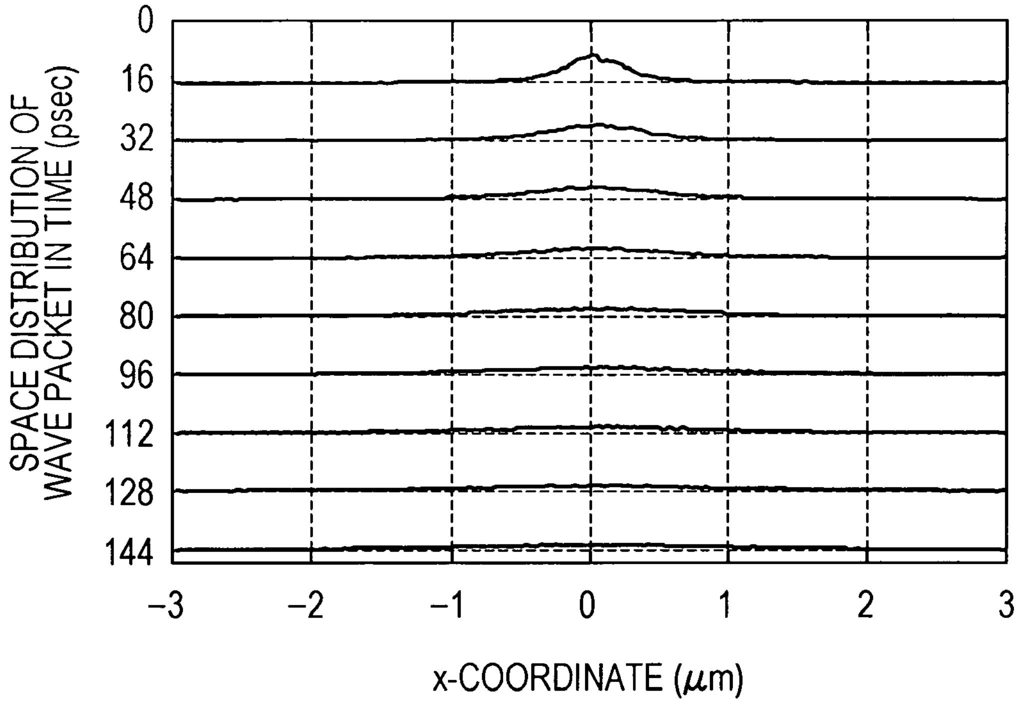


FIG. 14B

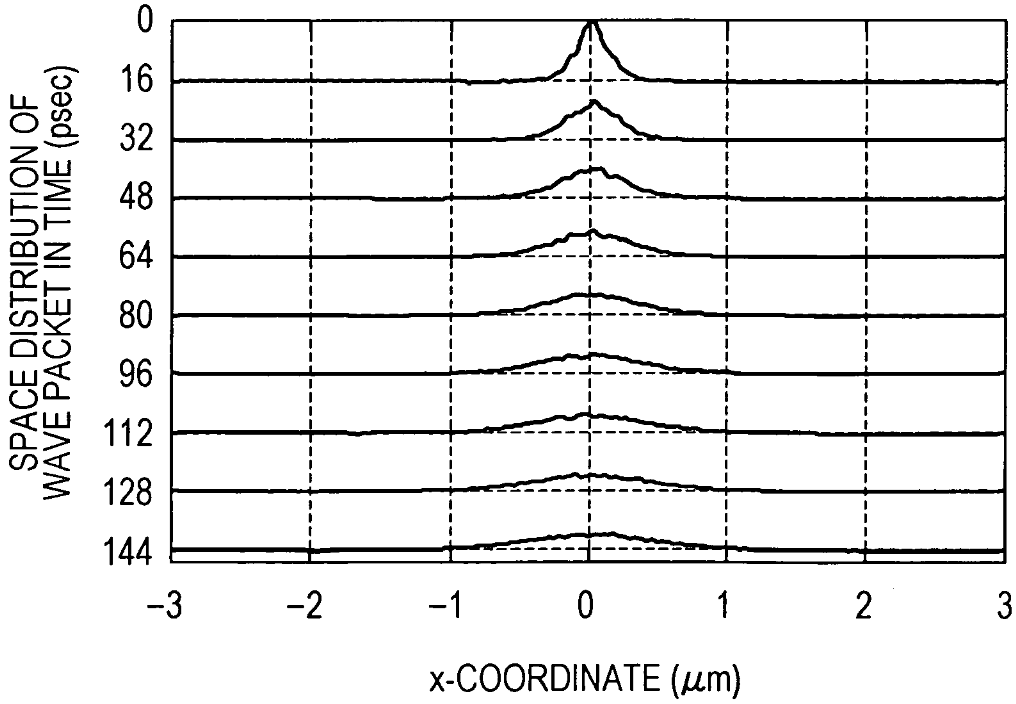

FIG. 15A

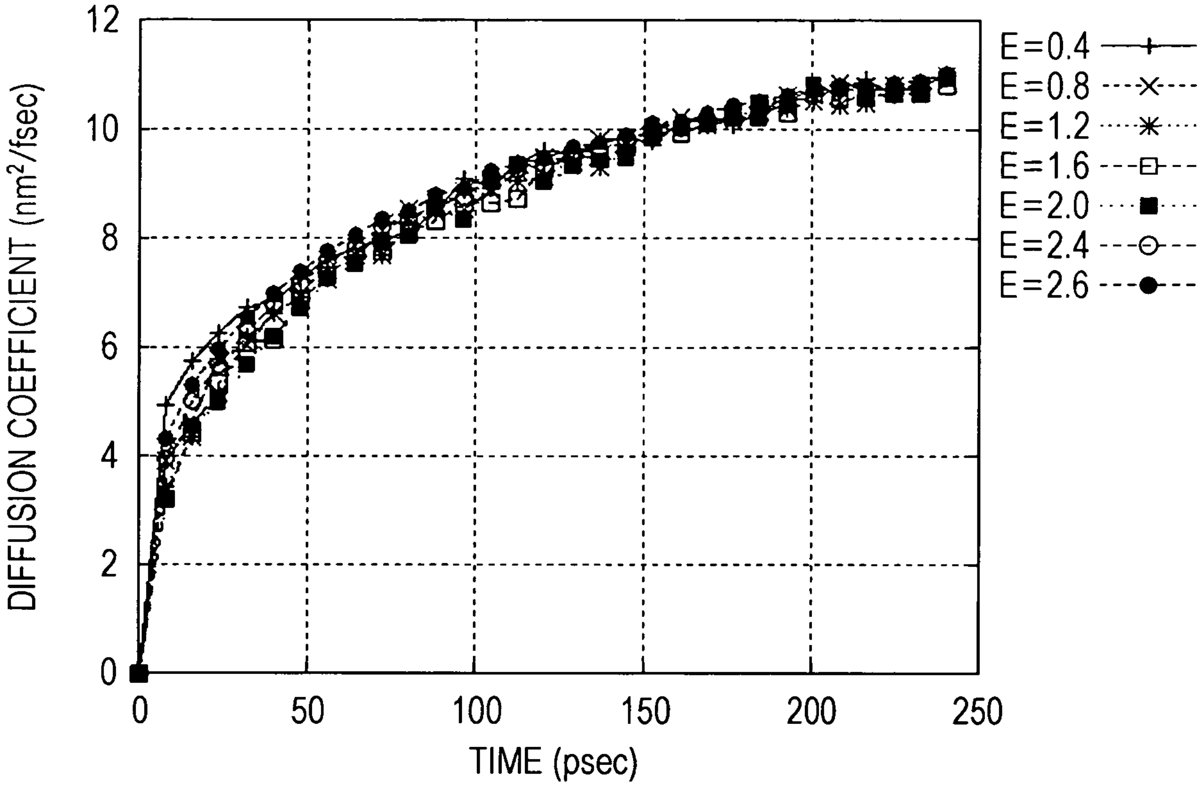


FIG. 15B

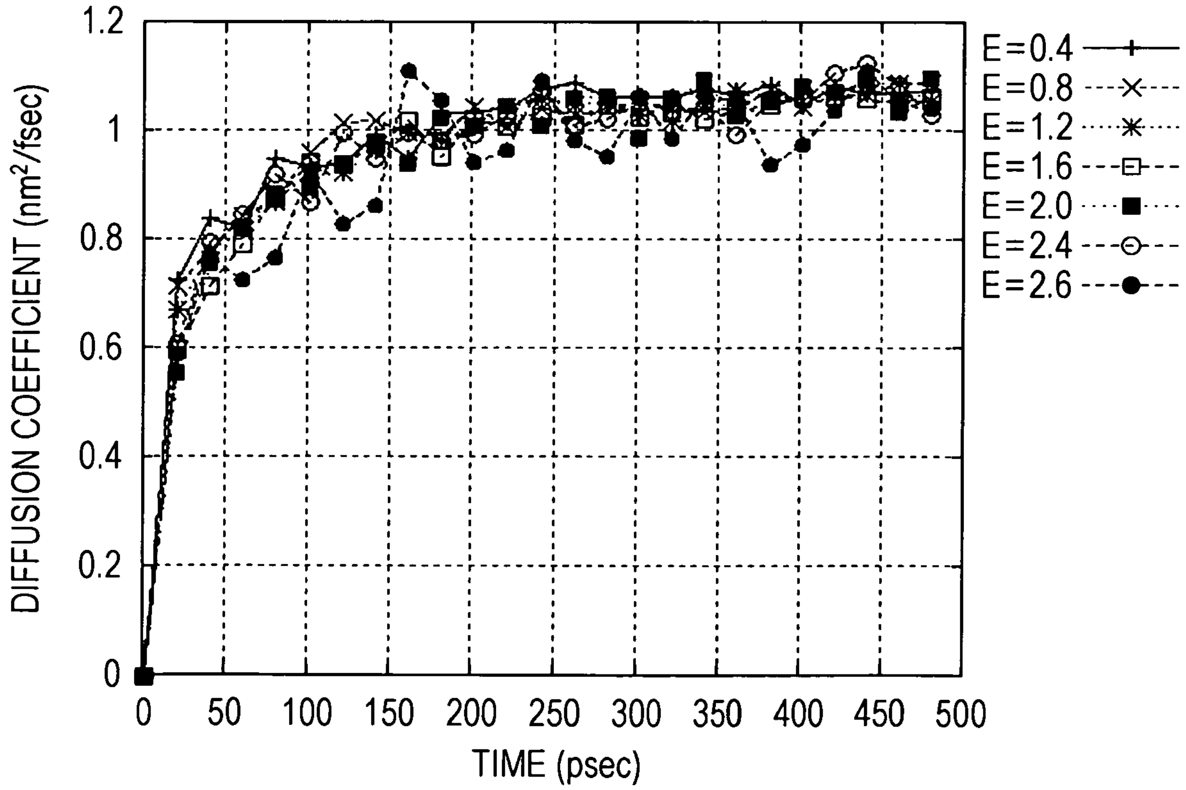

FIG. 16A

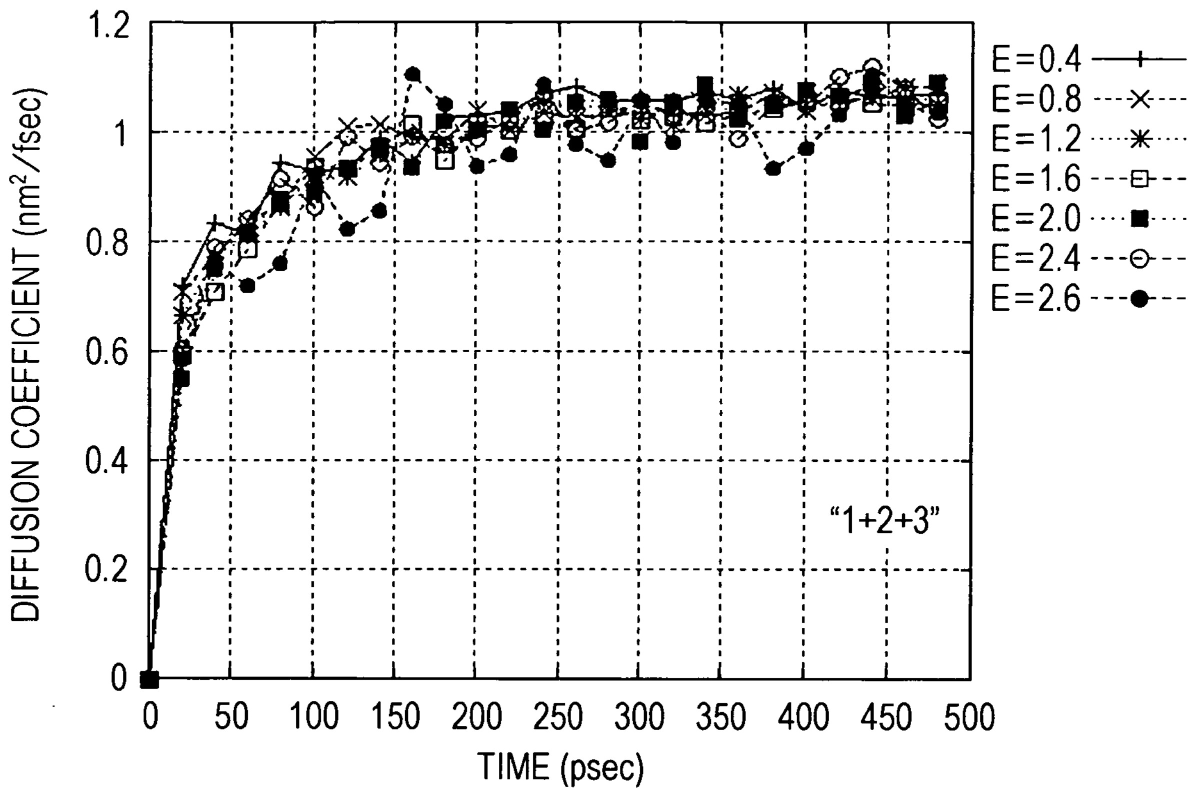


FIG. 16B

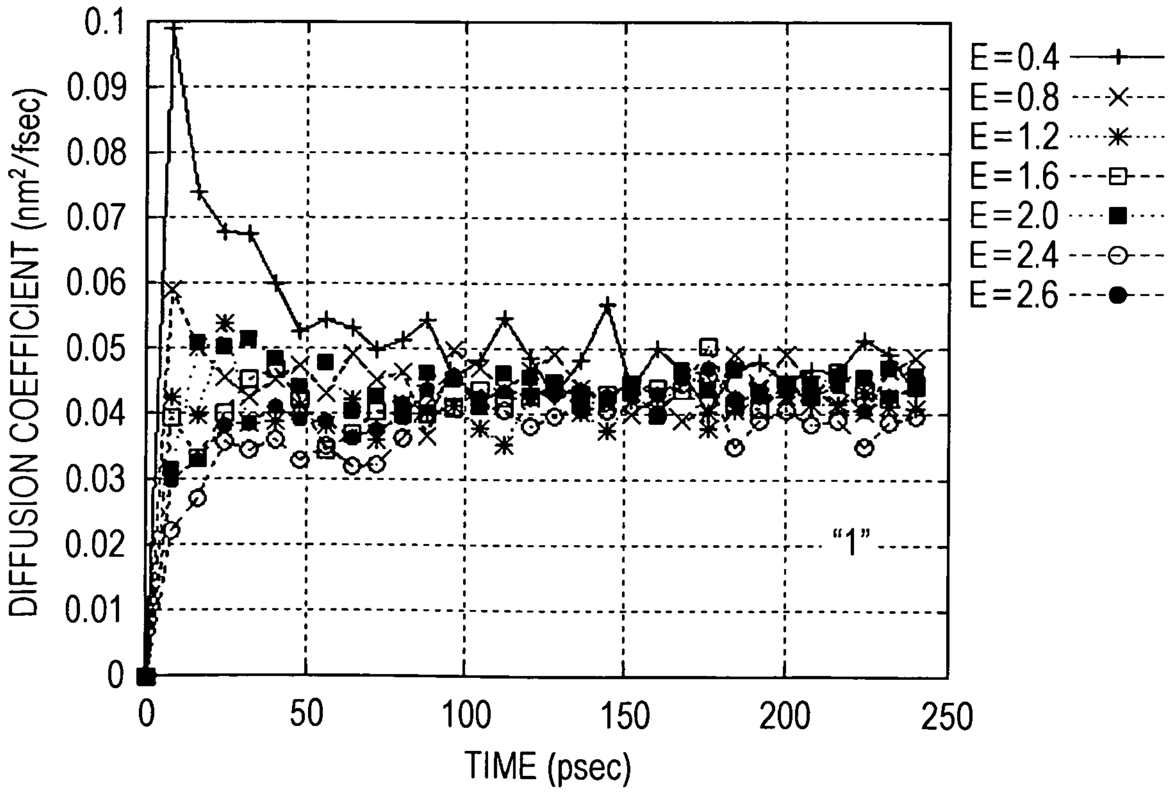

FIG. 16C

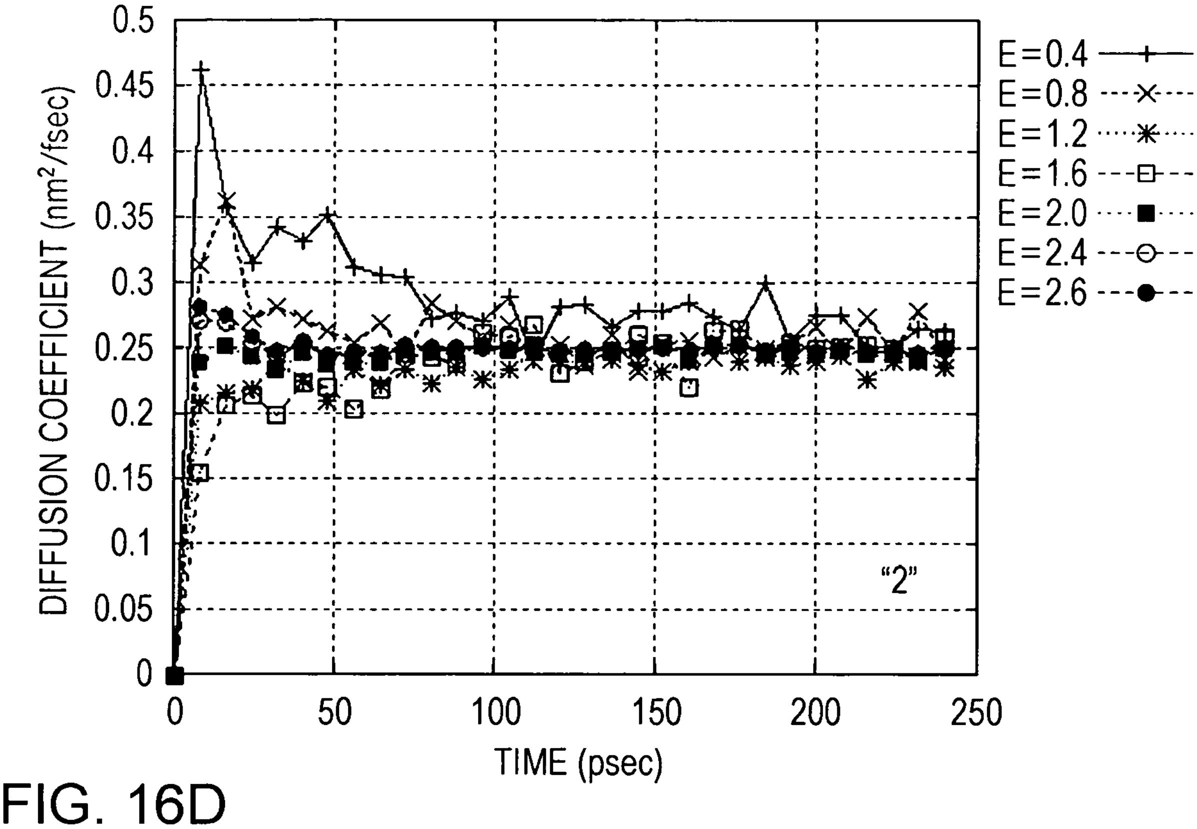


FIG. 16D

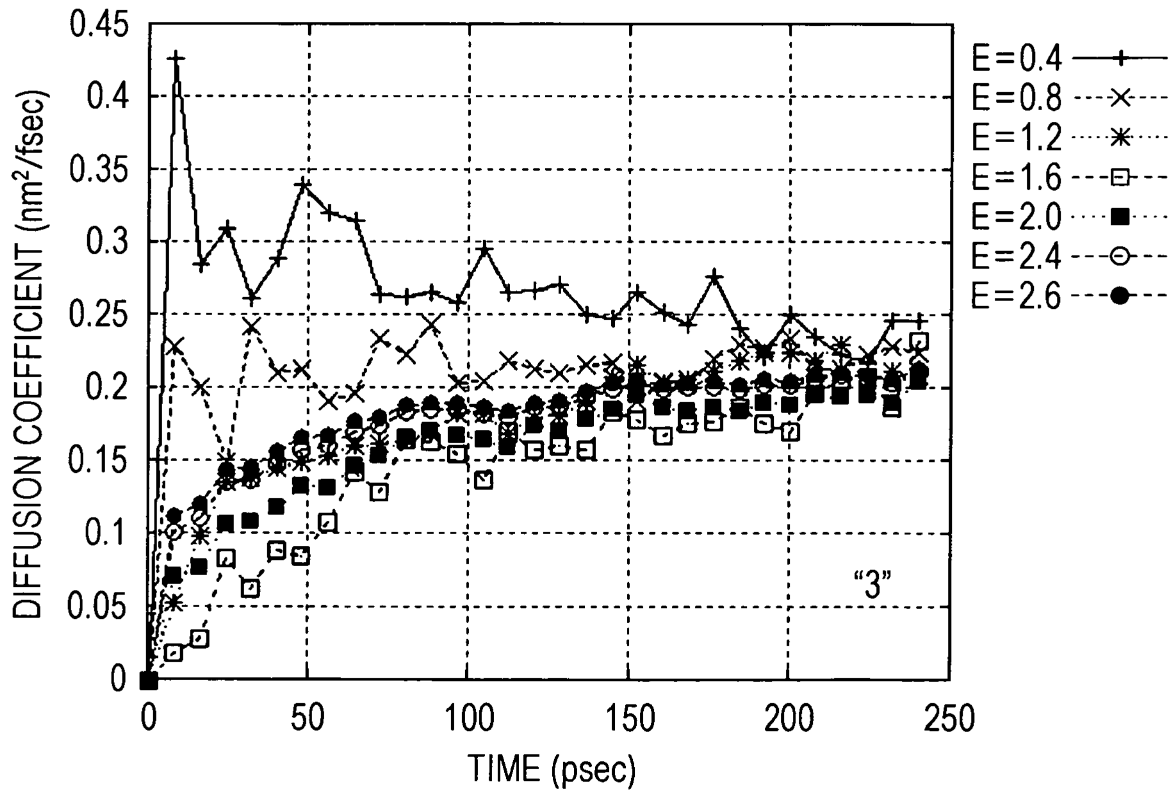

FIG. 16E

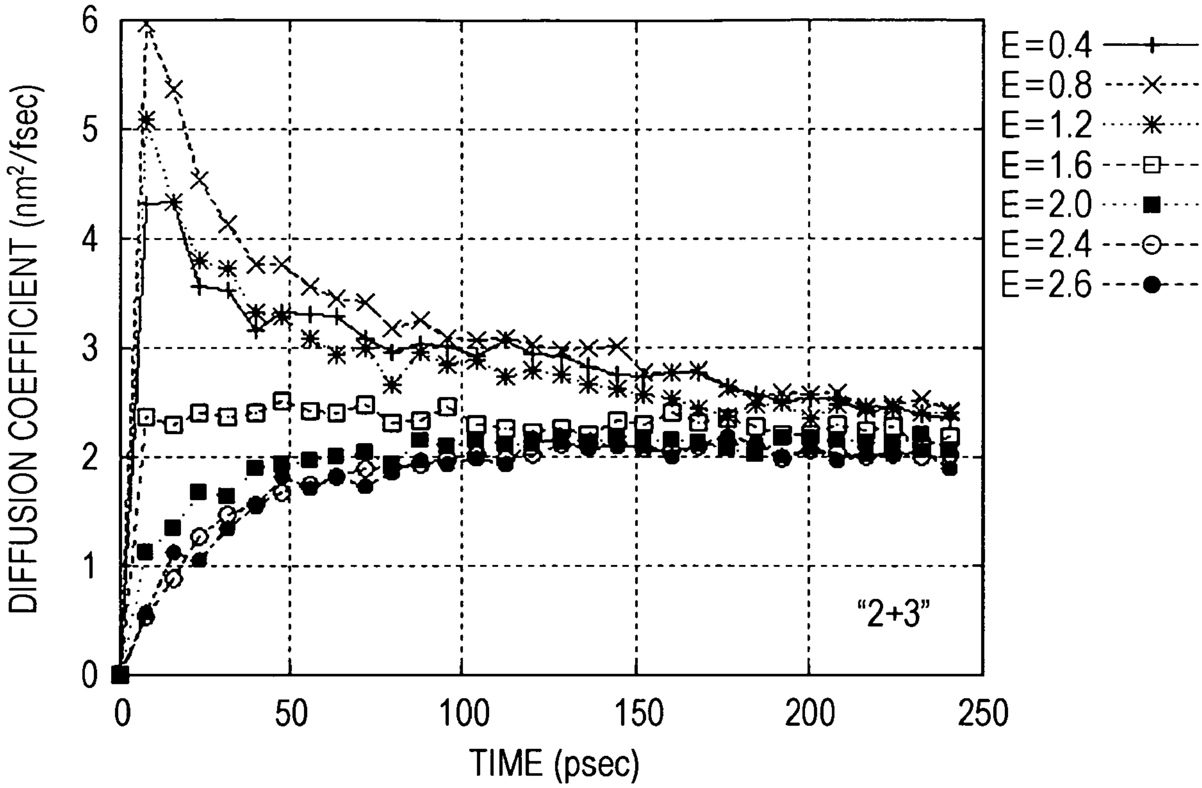


FIG. 16F

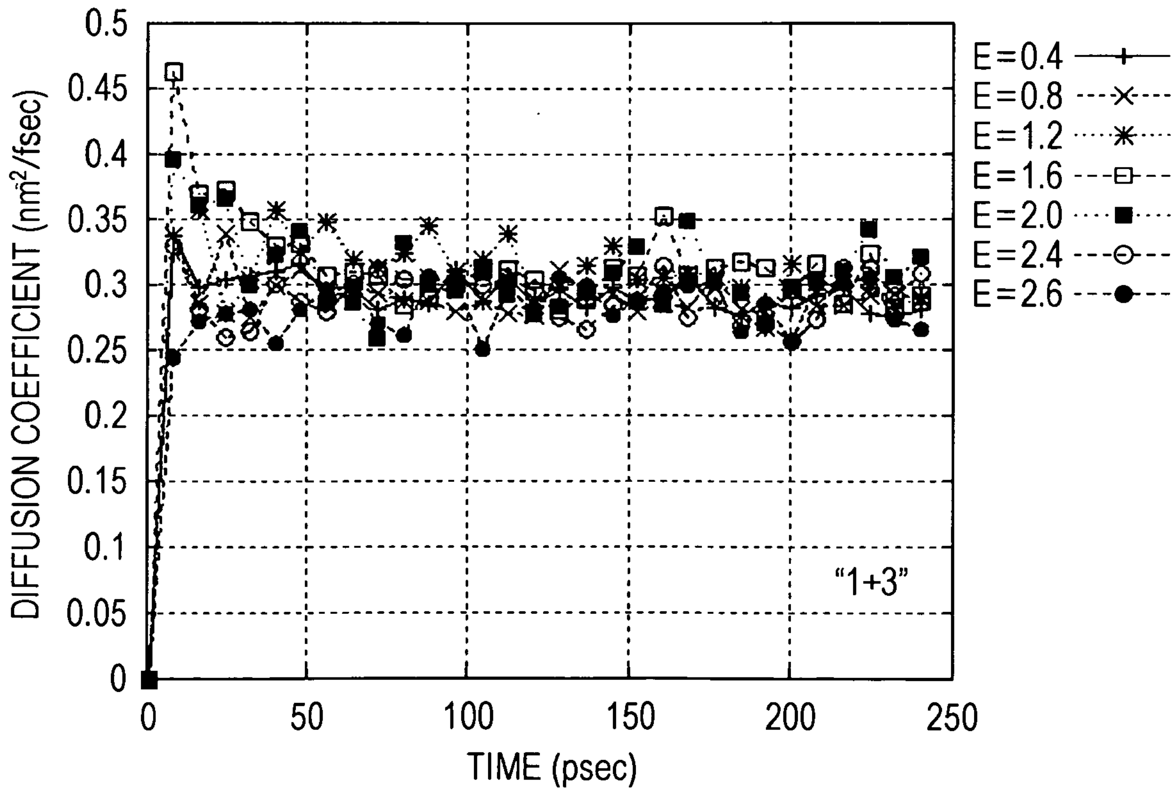

FIG. 16G

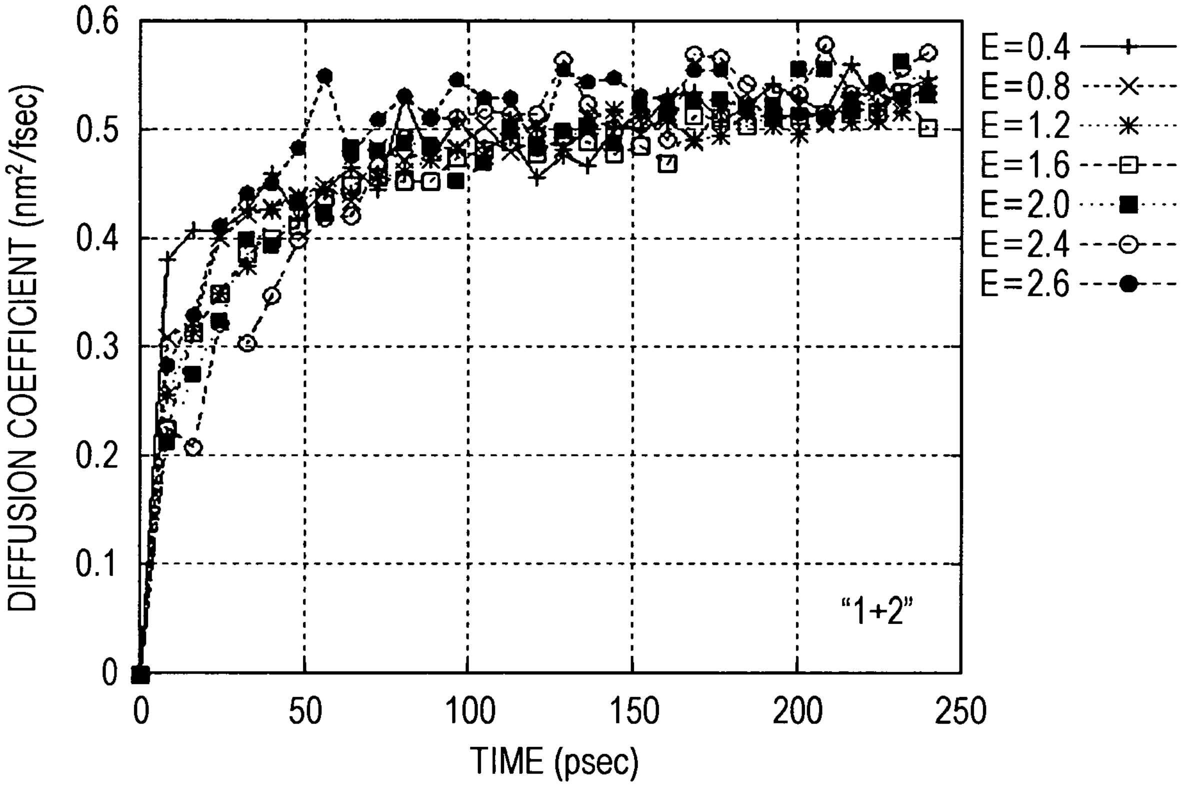
0.6
0.5
0.4
0.3
0.2
0.1
0
DIFFUSION COEFFICIENT (nm²/fsec)
0
50
100
150
200
250
TIME (psec)
E=0.4
E=0.8
E=1.2
E=1.6
E=2.0
E=2.4
E=2.6
"1+2"

FIG. 17

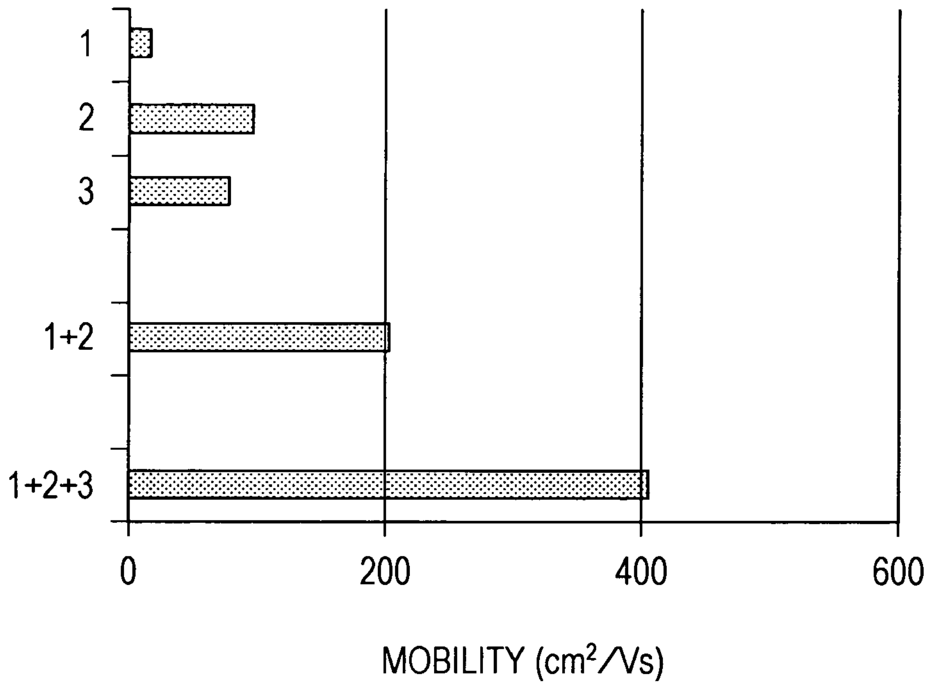
1
2
3
1+2
1+2+3
0
200
400
600
MOBILITY (cm²/Vs)

FIG. 18

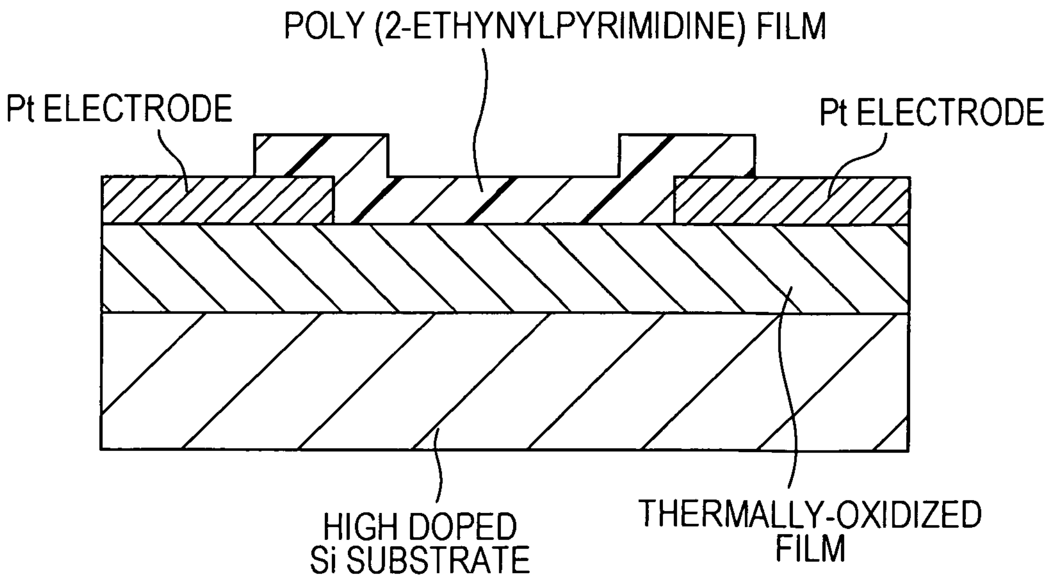
POLY (2-ETHYNYLPYRIMIDINE) FILM
Pt ELECTRODE
Pt ELECTRODE
HIGH DOPED
Si SUBSTRATE
THERMALLY-OXIDIZED
FILM

Europäisches Patentamt
European Patent Office
Office européen des brevets

# EUROPEAN SEARCH REPORT

Application Number
EP 12 00 1026

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>A | WO 2008/047586 A1 (CANON KK [JP]; SONE TAKEYUKI [JP]; KURIYAMA AKIRA [JP]; YANO KOJI [JP]) 24 April 2008 (2008-04-24)<br>* claims 1,9; figures; example 3 *<br>----- | 1,6<br>2-5 | INV.<br>C08F138/00<br>H01L51/00 |
| X | O ALBRECHT ET AL: "HELICAL POLYACETYLENE - A CONDUCTIVE MATERIAL FOR SELF-CONTAINED MOLECULAR ELECTRONIC DEVICE USE", NANOTECHNOLOGY, vol. 19, 505201, 24 November 2008 (2008-11-24), pages 1-7, XP002677295,<br>* figures 1a, 1b *<br>----- | 1,6 | |
| X | TABATA MASAYOSHI ET AL: "PI-Conjugated Columnar Polyacetylenes Prepared with Rh Complex Catalysts", MACROMOLECULAR SYMPOSIA, vol. 192, 2003, pages 75-97, XP002677296,<br>* abstract; tables 1,2 *<br>----- | 1-5 | |
| X | WO 2004/029111 A1 (NAT INST OF ADVANCED IND SCIEN [JP]; TABATA MASAYOSHI [JP]) 8 April 2004 (2004-04-08)<br>* figures 3,4,5a,5b *<br>----- | 1 | TECHNICAL FIELDS SEARCHED (IPC)<br>C08F<br>H01L |
| X | WO 2009/090852 A1 (CANON KK [JP]; SONE TAKEYUKI [JP]; ALBRECHT OTTO [JP]; YANO KOJI [JP]) 23 July 2009 (2009-07-23)<br>* page 6, line 3 - line 7; claims; examples *<br>-----<br>-/-- | 1 | |

The present search report has been drawn up for all claims

| Place of search | Date of completion of the search | Examiner |
|---|---|---|
| Munich | 6 June 2012 | Iraegui Retolaza, E |

4

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches Patentamt
European Patent Office
Office européen des brevets

# EUROPEAN SEARCH REPORT

Application Number
EP 12 00 1026

| DOCUMENTS CONSIDERED TO BE RELEVANT | | | |
|---|---|---|---|
| Category | Citation of document with indication, where appropriate, of relevant passages | Relevant to claim | CLASSIFICATION OF THE APPLICATION (IPC) |
| A | TING C H ET AL: "PHOTOLUMINESCENCE AND ELECTROLUMINESCENCE CHARACTERISTICS OF NEW DISUBSTITUTED POLYACETYLENES", JAPANESE JOURNAL OF APPLIED PHYSICS, vol. 40, no. 9A, PART 01, 1 September 2001 (2001-09-01), pages 5342-5345, XP001086989, JAPAN SOCIETY OF APPLIED PHYSICS, JP ISSN: 0021-4922, DOI: 10.1143/JJAP.40.5342 * the whole document * ----- | 1-5 | |
| A | SUN R ET AL: "LIGHT-EMITTING SUBSTITUTED POLYACETYLENES", JAPANESE JOURNAL OF APPLIED PHYSICS, vol. 38, no. 4A, PART 01, 1 April 1999 (1999-04-01), pages 2017-2023, XP000906648, JAPAN SOCIETY OF APPLIED PHYSICS, JP ISSN: 0021-4922, DOI: 10.1143/JJAP.38.2017 * the whole document * ----- | 1-5 | |
| | | | TECHNICAL FIELDS SEARCHED (IPC) |

The present search report has been drawn up for all claims

| Place of search | Date of completion of the search | Examiner |
|---|---|---|
| Munich | 6 June 2012 | Iraegui Retolaza, E |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

4

EPO FORM 1503 03.82 (P04C01)

**ANNEX TO THE EUROPEAN SEARCH REPORT ON EUROPEAN PATENT APPLICATION NO.** EP 12 00 1026

This annex lists the patent family members relating to the patent documents cited in the above-mentioned European search report.
The members are as contained in the European Patent Office EDP file on
The European Patent Office is in no way liable for these particulars which are merely given for the purpose of information.

06-06-2012

| Patent document cited in search report | Publication date | Patent family member(s) | Publication date |
|---|---|---|---|
| WO 2008047586 A1 | 24-04-2008 | AT 449427 T | 15-12-2009 |
| | | CN 102157690 A | 17-08-2011 |
| | | EP 2016632 A1 | 21-01-2009 |
| | | US 2009179197 A1 | 16-07-2009 |
| | | WO 2008047586 A1 | 24-04-2008 |
| WO 2004029111 A1 | 08-04-2004 | AU 2003264469 A1 | 19-04-2004 |
| | | JP 3903176 B2 | 11-04-2007 |
| | | JP 2004115628 A | 15-04-2004 |
| | | WO 2004029111 A1 | 08-04-2004 |
| WO 2009090852 A1 | 23-07-2009 | AT 523534 T | 15-09-2011 |
| | | EP 2235081 A1 | 06-10-2010 |
| | | JP 2009167293 A | 30-07-2009 |
| | | US 2010286336 A1 | 11-11-2010 |
| | | WO 2009090852 A1 | 23-07-2009 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2004029111 A1
- JP 2008084980 A


### Non-patent literature cited in the description


- **J. C. SLATER ; G. F. KOSTER.** *Phys. Rev.,* 1954, vol. 94, 1498
- **H. ISHII ; N. KOBAYASHI ; K. HIROSE.** *Phys. Rev., B,* 2007, vol. 76, 205432
- **E. T. SABOURIN.** *J. Org. Chem.,* 1983, vol. 48 (25